# EUROPEAN PATENT SPECIFICATION

(11) **EP 3 935 736 B1**
(45) Date of publication and mention of the grant of the patent: **21.02.2024**
(21) Application number: 20709195.0
(22) Date of filing: 06.03.2020
(51) Int. Cl.: H03K 17/06

(54) **TRANSISTOR ARRANGEMENT**
VERFAHREN ZUM BETRIEB EINER SUPERJUNCTION-TRANSISTORVORRICHTUNG
PROCÉDÉ DE FONCTIONNEMENT D'UN DISPOSITIF DE TRANSISTOR À SUPERJONCTION

(30) Priority: 08.03.2019 EP 19161485; 20.01.2020 WO PCT/EP2020/051245
(43) Date of publication of application: 12.01.2022
(73) Proprietor: Infineon Technologies Austria AG, 9500 Villach (AT)
(72) Inventor: WEBER, Hans, 83457 Bayerisch Gmain (DE); RIEGLER, Andreas, 9241 Lichtpold (AT); KUTSCHAK, Matteo-Alessandro, 9072 Ludmannsdorf (AT)
(74) Representative: Westphal, Mussgnug & Partner, Patentanwälte mbB
(86) International application number: PCT/EP2020/056018
(87) International publication number: WO 2020/182658

(56) References cited:
- US-A1- 2014 063 882
- US-A1- 2015 179 633

## Description

This disclosure relates in general to a transistor arrangement, in particular a transistor arrangement with a superjunction transistor device.

A superjunction transistor device, which may also be referred to as superjunction MOSFET, may receive across a load path a voltage with a first polarity or a voltage with a second polarity opposite the first polarity. When the load path voltage has the first polarity the MOSFET can be operated in an on-state (switched on state) or an off state (switched off state) by applying a suitable drive voltage to a drive input. When the load path voltage has the second polarity the MOSFET is in a conducting state independent off the drive voltage received at the drive input.

When the load path voltage has the second polarity the MOSFET can be operated in the on-state or the off-state. In the off-state, an internal body diode is forward biased. The operating state in which the MOSFET is in the off-state and the load path voltage has the second polarity may also be referred to as diode state of the MOSFET.

When the MOSFET operates in the diode state, there is a charge carrier plasma including both n-type charge carriers (electrons) and p-type charge carriers (holes) in a drift region of the MOSFET. When the polarity of the load path voltage changes such that the body diode is reverse biased these charge carriers have to be removed before the MOSFET blocks. Further, when the charge carriers forming the plasma have been removed, so that the MOSFET blocks, and as the load path voltage increases a depletion region (space charge regions) is formed in the drift region. Forming this depletion region is associated with a removal of free charge carriers in the drift region and the body region and, therefore, a storing of a fixed net charge in the drift and body region. In a superjunction device, the depletion region also expands in a compensation region that adjoins the drift region and has a doping type complementary to a doping type of the drift region.

Removing the charge carriers of the charge carrier plasma from the transistor device and charging the drift, body and the compensation regions is associated with a charging current, which may also be referred to as reverse recovery current. This current is associated with losses. Basically, the losses associated with changing the operating state of the transistor device from the diode state to the blocking state are given by the integral of the reverse recovery current multiplied with the voltage across a current path through which the charging current flows These losses may occur in the transistor device itself, but may also occur in devices connected to the transistor device. For example, the transistor device may be used as one of two switches in a half-bridge and the change of the operating state of the transistor device from the diode state to the blocking state may be caused by a change of the operating state of the other one of the two switches. In this case, the reverse recovery current may not only flow through the transistor device itself, but may also flow through the other one of the switches, where it may cause losses. The overall losses associated with changing the operating state of the transistor device may be referred to as commutation losses.

US 2015/0179633 A1 discloses a transistor arrangement with a reverse blocking MOSFET. The MOSFET includes a drift region and a drift control region dielectrically insulated from the drift region. The transistor arrangement further includes a biasing source and a capacitive element, wherein the capacitive element is connected between the biasing source and a source node of the MOSFET. The drift control region is configured to generate a conducting channel in the drift region and is connected to the biasing source and the capacitive element via an electronic switch, wherein a voltage limiting circuit is connected in parallel with the electronic switch.

US 2014/0063882 A1 discloses an electronic circuit with a transistor device, wherein the transistor device is either a MOSFET with a drift region and a drift control region dielectrically insulated from the drift region, or a superjunction MOSFET.

There is a need for reducing losses that are associated with a transition of a superjunction transistor device from a diode state to a blocking state.

One example relates to a transistor arrangement according to claim 1.

Examples are explained below with reference to the drawings. The drawings serve to illustrate certain principles, so that only aspects necessary for understanding these principles are illustrated. The drawings are not to scale. In the drawings the same reference characters denote like features.
Figure 1 illustrates one example of a transistor arrangement that includes a superjunction transistor device integrated in a semiconductor body, a bias region integrated in the semiconductor body, a bias voltage source, and an optional bias switch;
Figures 2A and 2B show one example of a transistor arrangement of the type shown in Figure 1 in greater detail;
Figure 3 shows a modification of the transistor arrangement shown in Figures 2A and 2B;
Figures 4A and 4B show further modifications of the transistor arrangement shown in Figures 2A and 2B;
Figures 5A and 5B illustrate examples of isolation trenches shown in Figures 4A and 4B;
Figure 6 illustrates one example of a transistor arrangement in which a diode is connected between the bias voltage source and the bias region;
Figure 7 illustrates one example in which the diode illustrated in Figure 6 is implemented as a Schottky diode;
Figures 8 to 13C illustrate various different implementations of the bias region and the bias switch;
Figure 14 illustrates one example of an electronic circuit in which the transistor arrangement of the type illustrated in Figure 1 may be used;
Figures 15 and 16 show signal waveforms that illustrate different examples of a method for operating the electronic circuit shown in Figure 14;
Figure 17 illustrates one example of a transistor arrangement that is based on the transistor arrangement shown in Figure 1 and includes a bias capacitor;
Figures 18A and 18B show one example of a transistor arrangement of the type shown in Figure 17 in greater detail;
Figure 19 shows another example of a transistor arrangement of the type shown in Figure 17 in greater detail;
Figure 20 shows a modification of the transistor arrangement shown in Figure 17;
Figure 21 illustrates one example of how the transistor arrangement shown in Figure 18 may be implemented;
Figure 22 schematically illustrates a circuit diagram of one example of a transistor arrangement that includes a clamping circuit;
Figure 23 illustrates one example of the clamping circuit in detail;
Figure 24 illustrates, in a transistor arrangement of the type shown in Figures 22 and 23, one example of the superjunction transistor device in detail; and
Figure 25 illustrates a modification of the transistor arrangement shown in Figure 22.

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

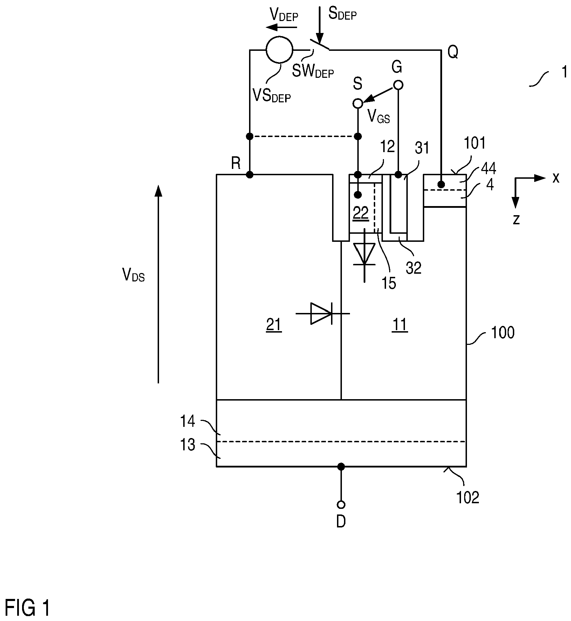

Figure 1 schematically illustrates a transistor arrangement 1 with a transistor device. More specifically, Figure 1 shows a vertical cross sectional view of a semiconductor body 100 in which the transistor device is integrated and circuit symbols of further electronic devices of the transistor arrangement. It should be noted that Figure 1 schematically illustrates some features of the transistor device in order to explain its functionality. These features may be arranged in the semiconductor body 100 in various ways. Thus, Figure 1 rather illustrates which features the transistor device includes, than a specific implementation. Examples for implementing the transistor device are explained in detail herein further below.

Referring to Figure 1, the transistor device includes a drift region 11 of a first doping type (first conductivity type), a source region 12 of the first doping type and a body region 22 of a second doping type (second conductivity type) complementary to the first doping type. One of the first doping type and the second doping type is an n-type and the other one of the first doping type and the second doping type is a p-type. The body region 22 separates the source region 12 from the drift region 11. Further, the body region 22 adjoins the drift region 11 so that a pn-junction (represented by a diode in Figure 1) is formed between the body region 22 and the drift region 11. This pn-junction is referred to as first pn-junction in the following. Each of the source region 12 and the body region 22 is connected to a source node S of the transistor device.

According to one example, each of the source region 12 and the body region 22 is connected to the source node S such that an ohmic contact is formed between the source node S and the respective device region 12, 22. The source node S may be formed by a source metallization (not illustrated) so that the ohmic contact between source and body regions 12, 22 and the source node S may include an ohmic contact between the source and body regions 12, 22 and the source metallization.

A gate electrode 31 is arranged adjacent the body region 22 and is dielectrically insulated from the body region 22 by a gate dielectric 32. The gate electrode 32 is connected to a gate node G and serves to control a conducting channel in the body region 22 along the gate dielectric 32 between the source region 12 and the drift region 11.

The transistor device further includes a drain region 13 of the first doping type. The drain region 13 is connected to a drain node D, is spaced apart from the body region 22 in a current flow direction of the transistor device and is separated from the body region 22 by the drift region 11. Optionally, a buffer region 14 of the first doping type is arranged between the drain region 13 and the drift region 11. The buffer region 14 has a lower doping concentration than the drift region 11, for example.

The transistor device is implemented as a superjunction transistor device and further includes a compensation region 21 of the second doping type. The compensation region 21 adjoins the drift region 11 and may or may not adjoin the body region 22. More detailed examples with regard to the arrangement of the compensation region 21 relative to the body region 22 are explained herein further below. As the doping type of the compensation region 21 is complementary to the doping type of the drift region 11 a further pn-junction (represented by a diode in Figure 1) is formed between the compensation region 21 and the drift region 11. This pn-junction is referred to as second pn-junction in the following. Referring to Figure 1, the drift region 11 and the compensation region 21 may be implemented in such a way that the second pn-junction essentially extends in the current flow direction. Optionally, as illustrated in dashed lines in Figure 1, the compensation region 21 is connected to the source node S.

The transistor device further includes a bias region 4. The bias region 4 is a doped region of either the first doping type or the second doping and is coupled to the drift region 11. "Coupling the bias region 4 to the drift region 11" includes electrically coupling the bias region 4 to the drift region 11 in any possible way and may include directly coupling the bias region 4 to the drift region 11 such that the bias region 4 adjoins the drift region 11 or may include indirectly coupling the bias region 4 to the drift region 11. "Indirectly coupling the bias region 4 to the drift region 11" may include coupling the bias region 4 to the drift region 11 via an electronic switch such as a transistor, for example.

Just for the purpose of illustration, in the transistor device shown in Figure 1, the current flow direction of the transistor device corresponds to a vertical direction z of the semiconductor body 100. The "vertical direction z" of the semiconductor body 100 is a direction perpendicular to a first surface 101 and a second surface 102, wherein the second surface 102 is spaced apart from the first surface 102. In addition to the first and second surfaces 101, 102, which may also be referred to as front and rear surfaces, the semiconductor body 100 includes side surfaces (edge surfaces) that each extend from the first surface 101 to the second surface 102. These side surfaces, however, are out of view in the section of the semiconductor body 100 illustrated in Figure 1.

A transistor device of the type shown in Figure 1 in which the current flow direction corresponds to the vertical direction of the semiconductor body 100 may be referred to as vertical transistor device. Implementing the transistor device as a vertical transistor device, however, is only an example. The principles explained hereinbefore and hereinabove also apply to a lateral transistor device, which is a transistor device in which the current flow direction corresponds to a lateral direction of the semiconductor body 100. The "lateral direction" is a direction parallel to the first and second surfaces 101, 102 of the semiconductor body.

According to one example, the semiconductor body 100 includes a monocrystalline semiconductor material. Examples of the monocrystalline semiconductor material include, but are not restricted to, silicon (Si), silicon carbide (SiC), gallium arsenide (GaAs), gallium nitride (GaN), or the like.

According to one example, the semiconductor body 100 includes monocrystalline silicon and the individual active device regions are implemented such that a respective doping concentration is in a range as outlined in the following:
drift region 11: between 1E15 cm⁻³ and 1E17 cm⁻³;
compensation region 21: between 1E15 cm⁻³ and 1E17 cm⁻³;
body region 22: between 1E17 cm⁻³ and 1E18 cm⁻³;
source region 12: between 1E18 cm⁻³ and 1E21 cm⁻³;
drain region 13: between 1E18 cm⁻³ and 1E21 cm⁻³;
optional buffer region 14: between 5E14 cm⁻³ and 1E17 cm⁻³.

Referring to the above, the bias region 4 may be implemented as a doped region of (1) the first doping type, or (2) the second doping type. In the first case (1), the doping concentration of the bias region 4 is in a range of between 1E16 cm⁻³ and 1E21 cm⁻³, for example. In the second case (2), the doping concentration is in a range of between 1E15 cm⁻³ and 1E18 cm⁻³, for example. In the second case, the bias region 4 may be formed by the same process that forms the body region 22, so that the doping concentrations of the body region 22 and the bias region 4 may essentially be the same.

Referring to the above, an ohmic contact may be formed between the body region 22 and the source node S. In this case, the body region 22 may include a contact region (not shown) of the second doping type, wherein a doping concentration of the contact region is high enough, to achieve an ohmic contact between the source node S (the source metallization) and the body region 22. The doping concentration is between 1E18 cm⁻³ and 1E21 cm⁻³, for example.

Referring to Figure 1, the bias region 4 is connected to a bias node Q, which is explained in detail herein further below. According to one example, an ohmic contact is formed between the bias region 4 and the bias node Q. In this case, the bias region 4 may include a contact region 44 (illustrated in dashed lines) that is of the same doping type as the bias region 4 and has a doping concentration that is high enough to achieve an ohmic contact between a bias node Q and the body region 22. The doping concentration of the contact region 44 is between 1E18 cm⁻³ and 1E21 cm⁻³, for example. Such contact region 44 may be included in each of the examples explained below, although the contact region 44 is not illustrated in the further examples. The bias node Q may be formed by a metallization (not shown) separate from the source metallization.

The doping type of the source, drift and drain regions 12, 11, 13 defines the conductivity type of the superjunction transistor device. These device regions 12, 11, 13 are regions of the first doping type so that the superjunction transistor device is a transistor device of the first conductivity type. More specifically, the superjunction transistor device is an n-type transistor device when the semiconductor regions of the first doping type are n-type semiconductor regions and the semiconductor regions of the second doping type are p-type semiconductor regions, and the superjunction transistor device is a p-type transistor device when the semiconductor regions of the first doping type are p-type semiconductor regions and the semiconductor regions of the second doping type are n-type semiconductor regions. Further, the transistor device can be implemented as an enhancement (normally-off) device or as a depletion (normally-on) device. In an enhancement device, the body regions 22 adjoin the gate dielectric 32. In a depletion device, there is a channel region 15 (illustrated in dashed lines) of the first doping type that extends from the source region 12 to the drift region 11 along the gate dielectric 32 and is arranged between the gate dielectric 32 and the body region 22.

In the transistor device shown in Figure 1, a load path is formed between the drain node D and the source node S. A voltage V_{DS} between these nodes is referred to as load path voltage or drain-source voltage in the following. A drive input is formed by the gate node G and the source node S, for example. A voltage V_{GS} received at the drive input is referred to as drive voltage or gate-source voltage in the following. Dependent on a voltage level of the drive voltage V_{GS} a conducting channel is formed along the gate dielectric 32 in the body region 22 between the drift region 11 and the source region 12.

In a n-type enhancement transistor device, for example, a conducting channel is generated along the gate dielectric 32 when the voltage level of the drive voltage V_{GS} is higher than a threshold voltage of the transistor device. The threshold voltage is dependent on the conductivity type of the transistor device and dependent on whether the transistor device is an enhancement device or a depletion device. This is commonly known, so that no further explanation is required in this regard.

The superjunction transistor device shown in Figure 1 can be operated in four different operating states:
(a) In a first operating state (which is also referred to as forward conducting state in the following), the gate electrode 32 is controlled such that there is a conducting channel in the body region 22 along the gate dielectric 32 between the source region 12 and the drift region 11. Further, in the first operating state, a voltage applied between the drain node D and the source node S has a first polarity such that the first pn-junction between the drift region 11 and the body region 22 is reverse biased. In an n-type transistor device, for example, the first pn-junction between the drift region 11 and the body region 22 is reverse biased when the load path voltage V_{DS} is a positive voltage. In this operating state, a unipolar current can flow between the drain node D and the source node S via the drain region 13, the optional buffer region 14, the drift region 11, the channel in the body region 22 along the gate dielectric 32, and the source region 12. In an n-type transistor device, for example, the unipolar current includes electrons as charge carriers.
(b) In a second operating state (which is also referred to as reverse conducting state in the following), the gate-source voltage V_{GS} is such that there is a conducting channel in the body region 22 along the gate dielectric 32, which is similar to the first operating state explained above. In the second operating state, however, the drain-source voltage V_{DS} has a second polarity that is opposite the first polarity in the first operating state , so that a current can flow between the drain node D and the source node S. In the second operating state the current flows in a direction that is opposite to the direction of the current flow in the first operating state. Basically, the current is a unipolar current and flows between the drain node D and the source node S via the drain region 13, the optional buffer region 14, the drift region 11, the channel in the body region 22 along the gate dielectric 32, and the source region 12. However, situations may occur in which a voltage across the first pn-junction between the body region 22 and the drift region 11 becomes higher than a forward voltage of this pn-junction, so that in the reverse conducting state, parallel to the conducting channel in the body region 22, a bipolar diode formed by the body region 22, the drift region 11 and the drain region 13 becomes active and a bipolar current sets in.
(c) In a third operating state, the gate-source voltage V_{GS} is such that there is no conducting channel in the body region 22 along the gate dielectric 32. Further, in the third operating state, the drain-source voltage V_{DS} has the second polarity so that the first pn-junction between the body region 22 and the drift region 11 is forward biased. This operating state is also referred to as diode state in the following.
(d) In the fourth operating state, the gate-source voltage V_{GS} is such that there is no conducting channel in the body region 22 along the gate dielectric 32. Further, in the fourth operating state, the drain-source voltage has the first polarity, that is, a polarity of the drain-source voltage V_{DS} is such that the pn-junction between the body region 22 and the drift region 11 is reverse biased. This operating state is also referred to as blocking state in the following.

In the third operating state (diode state) charge carriers of the first conductivity type are injected by the drain region 13 into the drift region 11 and charge carriers of the second conductivity type are injected by the body region 22 into the drift region 11 so that there is a charge carrier plasma including charge carriers of the first and second conductivity type primarily in the drift region 11, the compensation region 21 and the optional buffer region 14. In an n-type transistor device, the charge carriers injected by the drain region 13 are electrons and the charge carriers injected by the body region 22 are holes.

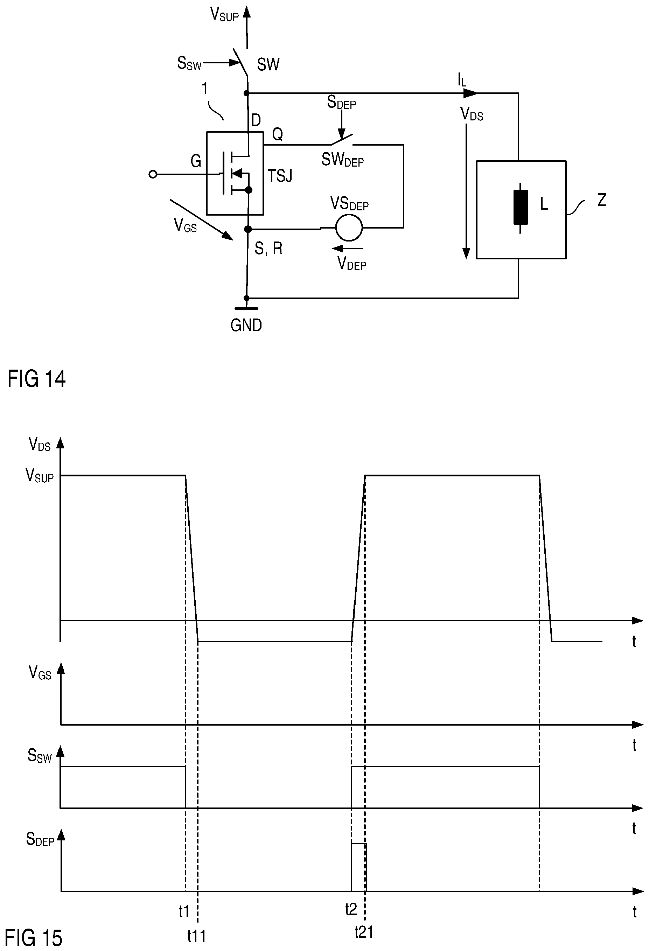

When the transistor device changes from the diode state into the (forward biased) blocking state (the fourth operating state), for example, the charge carriers forming the charge carrier plasma need to be removed from the drift region 11 before the transistor device blocks, that is, before a current through the transistor device turns to zero. Furthermore, in the blocking state, charge carriers are stored in a junction capacitance that is formed by the first pn-junction (the pn-junction between the body region 22 and the drift region 11) and the second pn-junction(the pn-junction between the drift region 11 and the compensation region 21. Switching the superjunction transistor device from the diode state to the blocking state is associated with losses, wherein these losses are essentially given by the integral of the current that removes the charge carrier plasma and charges the junction capacitance multiplied with the voltage across a current path through which the current flows. These losses may occur in the transistor device 1 itself, but may also occur in an external device such as another transistor device connected in series with the transistor device 1. The latter is explained with reference to Figure 14 herein further below.

In the transistor device 1 according to Figure 1, losses associated with changing the operating state of the transistor device from the diode state to the blocking state may be reduced by applying a bias voltage V_{DEP} between the bias region 4 and at least one of the compensation region 21 and the body region 22, wherein the bias voltage V_{DEP} is different from zero. As outlined in further detail herein below, a polarity of the bias voltage V_{DEP} is such that the pn-junction between the drift region 11 and the at least one of the compensation region 21 and the body region 22 is reverse biased, that is at least one of the second pn-junction and the first pn-junction is reverse biased. The bias voltage V_{DEP} may be provided by any kind of voltage source VS_{DEP} that is configured to provide the bias voltage V_{DEP} and is connected between the bias region 4 and the at least one of the compensation region 21 and the body region 22. This voltage source VS_{DEP} is referred to as bias voltage source in the following. A circuit node Q outside the semiconductor body 100 and connected between the voltage source providing the bias voltage V_{DEP} and the bias region 4 is referred to as bias node Q in the following.

According to one example, the bias voltage V_{DEP} is applied between the bias region 4 and only the compensation region 21. According to another example, the bias voltage V_{DEP} is applied between the bias region 4 and both the compensation region 21 and the body region 22. According to yet another example, the bias voltage V_{DEP} is applied between the bias region 4 and only the body region 22.

In Figure 1, reference character R denotes a circuit node connected to the compensation region 21. This circuit node R is referred to as further bias node in the following. In the example illustrated in Figure 1, the bias voltage V_{DEP} is applied between bias node Q (that is connected to the bias region 4) and the further bias node R (that is connected to the compensation region 21). The source node S and the further bias node R may be connected (as illustrated in dashed lines in Figure 1) or may even be formed by the same circuit node.

Optionally, the bias voltage V_{DEP} is selectively applied between the compensation region 21 and the bias region 4. This may be achieved by connecting a switch S_{DEP} in series with the voltage source that provides the bias voltage V_{DEP}. The switch SW_{DEP}, which is also referred to as bias switch in the following, is connected between the voltage source and the bias region 4 in the example shown in Figure 1. This, however, is only an example. The bias switch SW_{DEP} may be arranged at any position between the compensation region 21 and the drift region 11. Some examples for implementing the bias switch SW_{DEP} are explained herein further below.

According to one example, a magnitude of the bias voltage V_{DEP} is less than 20%, less than 10%, or even less than 5% of a voltage blocking capability of the superjunction transistor device. The "voltage blocking capability" is the maximum voltage the superjunction transistor device can withstand in the blocking state before an Avalanche breakdown occurs. According to one example, the voltage blocking capability is between 400V and 1500V. The magnitude of the bias voltage is between 10 volts (V) and 50 volts, in particular between 15 volts and 25 volts, for example.

In an n-type transistor device, a polarity of the bias voltage V_{DEP} may be such that (when the optional bias switch SW_{DEP} is in an on-state) the electrical potential of the bias region 4 is positive relative to the electrical potential at the compensation region 21.

Applying the bias voltage V_{DEP} between the compensation region 21 and the bias region 4, when the transistor device 1 is in the diode state, helps to reduce losses when the transistor device changes from the diode state to the blocking state. Losses that occur when the transistor device changes from the diode state to the blocking state include losses that are associated with removing the charge carrier plasma from the drift region 11 and the compensation region 21 and losses that are associated with storing charge carriers in the junction capacitance explained above (the losses associated with storing charge carriers in the junction capacitance are sometimes referred to as Qoss losses). Storing charge carriers in the junction capacitance is associated with a depletion region (space charge region) expanding in both the drift region 11 and the compensation region 21. The charge carrier plasma includes first type charge carriers injected by the drain region 13 and second type charge carriers injected by the body region 22 and the compensation region 21. In an n-type transistor device, for example, the first type charge carriers are electrons (n-type charge carriers) and the second type charge carriers are holes (p-type charge carriers).

Referring to the above, the bias voltage V_{DEP} is applied between the bias region 4 and at least one of the compensation region 21 and the body region 22 (the compensation region 21 and/or the body region 22). Applying the bias voltage V_{DEP} between the bias region 4 and at least one of the compensation region 21 and the body region 22 such that at least one of the second pn-junction and the first pn-junction is reverse biased has the effect that first type charge carriers (those resulting from the charge carrier plasma in the drift region 11 and the compensation region 21 and/or the body region 22 and those associated with charging the junction capacitance) are collected by the bias region 4 and flow via the bias node Q towards a first node of the voltage source providing the bias voltage V_{DEP}. Equivalently, second type charge carriers (those resulting from the charge carrier plasma in the drift region 11 and compensation region 21 and/or the body region 22 and those associated with charging the junction capacitance) flow via the compensation region 21 and/or the body region 22 to a second node opposite the first node of the voltage source. In an n-type transistor device, for example, the polarity of the bias voltage V_{DEP} is such that the potential at the first node of the voltage source is higher than the potential at the second node in order to reverse bias the second pn-junction and/or the first pn-junction. In this case, electrons of the charge carrier plasma flow towards the first node of the voltage source and holes flow towards the second node of the voltage source.

Removing charge carriers of the charge carrier plasma from the drift region 11 and at least one of the compensation region 21 and the body region 22 and charging the junction capacitance (that is, forming a depletion region in the drift region 11 and the compensation region 21) in the way explained above is associated with losses, wherein these losses are dependent on the current associated with removing the charge carriers of the plasma and forming the depletion region and are dependent on the bias voltage V_{DEP}. This current is referred to as current associated with a transition from the diode state to the blocking state. By suitably adjusting the voltage level of the bias voltage V_{DEP} however, these losses can significantly be reduced as compared to losses occurring in a conventional superjunction transistor device with the same voltage blocking capability and the same on-resistance (which is the resistance between the drain node and the source node in the forward conducting state).

The depletion voltage V_{DEP}, at least, is applied between the compensation region 21 and the bias region 4 when the transistor device is in a transient phase between the reverse conducting state and the blocking state. The transient phase includes that the transistor device is operated in the diode state. It may be desirable to operate the transistor device in the diode state as short as possible and, nevertheless, avoid a cross current. A cross current may occur when the voltage across the transistor has reversed its polarity and the transistor device is still in the on-state..

According to one example, the bias voltage V_{DEP} is applied in the transient phase until the drain-source voltage V_{DS} in the blocking state has reached a predefined threshold. The transistor arrangement may further include a drive circuit (not illustrated) that is configured to drive the bias switch SW_{DEP} such that the bias switch SW_{DEP} is switched on until the drain-source voltage V_{DS} in the blocking state has reached the predefined threshold. The bias voltage V_{DEP} may be applied between the bias region 4 and the compensation region 21 throughout the time period in which the transistor device is in the diode state or only for a predefined time period, such as less than 100 nanoseconds (ns) before the transition from the diode state to the blocking state takes place and, as mentioned above, during the transition. According to one example, the predefined time period is dependent on a load current that flows through the superjunction transistor device when the transistor device is in the diode state, wherein a duration of the time period increases as the load current increases.

According to another example, the bias switch SW_{DEP} is operated synchronously with the superjunction transistor device such that (a) the bias switch SW_{DEP} switches off each time the superjunction transistor device switches on, that is, each time the superjunction transistor device is either in the forward conducting state or the reverse conducting state, and (b) the bias switch SW_{DEP} switches on each time the superjunction transistor device switches off, that is, each time the superjunction transistor device is either in the diode state or the blocking state.

Referring to the above, Figure 1 schematically illustrates device regions included in the superjunction transistor device, rather than a specific implementation. More detailed examples of how these device regions may be arranged in the semiconductor body 100 and of how the superjunction transistor device may be implemented are explained in the following.

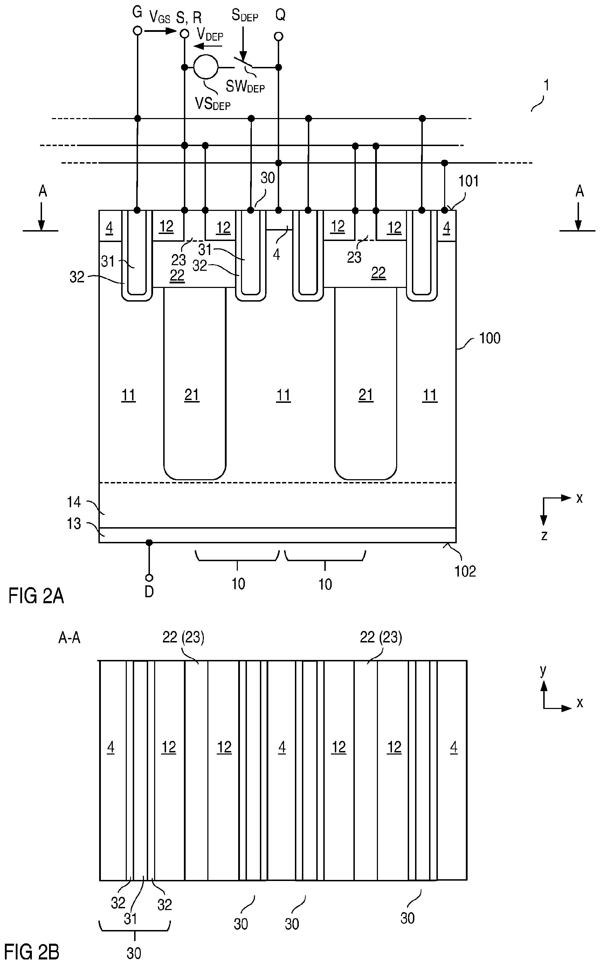

One example of the transistor device is illustrated in Figures 2A and 2B, wherein Figure 2A shows a vertical cross sectional view of a semiconductor body 100 in which the transistor device is integrated and Figure 2B shows a horizontal cross sectional view. The transistor device according to Figures 2A and 2B includes a plurality of transistor cells 10, wherein each transistor cell 10 includes device regions of the type explained with reference to Figure 1. That is, each transistor cell 10 includes: a drift region 11; a source region 12; a body region 22 separating the source region 12 from the drift region 11 and adjoining the drift region 11; a drain region 13 spaced apart from the body region 22 in a current flow direction; an optional buffer region 14; and a gate electrode 31 arranged adjacent to the body region 22 and dielectrically insulated from the body region 22 by a gate dielectric 32. Further, in the example shown in Figure 1 each transistor cell 10 further includes a bias region 4. Everything explained above with regard to the doping type and the doping concentration of the device regions illustrated in Figure 1 applies accordingly to the corresponding device regions in the transistor device shown in Figures 2A and 2B and the other transistor devices explained herein further below.

The transistor device shown in Figures 2A and 2B is a vertical transistor device. This, however, is only an example. A structure of the type illustrated in Figures 2A and 2B that includes a plurality of transistor cells may be used in a lateral transistor device as well.

Referring to Figure 1, the drift region 11 of two neighboring transistor cells 10 can be formed by one respective semiconductor region, the compensation region 21 of two neighboring transistor cells 10 can be formed by one respective semiconductor region, and the body region 22 of two neighboring transistor cells 10 can be formed by one respective contiguous semiconductor region. Further, the bias region 4 of two neighboring transistor cells 10 can be formed by one respective semiconductor region. Further, the drain region 13 (as well as the optional buffer region 14) of each of the transistor cells 10 can be formed by one contiguous semiconductor region.

In the example shown in Figures 2A and 2B, the gate electrodes 31 and the gate dielectrics are located in trenches that extend from the first surface 101 into the semiconductor body 100. The trenches with the gate electrodes 31 and the gate dielectrics 32 are referred to as gate trenches 30 in the following.

The transistor cells 10 are connected in parallel in that the gate electrodes 31 of the transistor cells 10 are connected to the gate node G, the source regions 12 and the body regions 22 of the transistor cells 10 are connected to the source node S, and the one or more drain regions 13 are connected to the drain node D. Further, each of the bias regions 4 is connected to the bias node Q. The gate node G, the source node S, the drain node D, and the bias node Q are only schematically illustrated in Figure 2A. Further, connections between the gate node G and the gate electrodes 31 and between the source node S, the drain node D and the bias node Q and the respective active device regions (source regions 12, body regions 22, drain regions 13, and bias regions 4) are only schematically illustrated in Figure 2A. These connections may include metallizations (not shown) on top of the first and second surfaces 101, 102.

Referring to the above, the body regions 22 of the transistor cells 10 are connected to the source node S. According to one example, the body region 22 includes a contact region 23 of the second doping type, wherein the contact region 23 is more highly doped than remaining sections of the body region 22. In particular, the contact region 23 is more highly doped than those sections of the body region 22 adjoining the gate dielectric 32. The contact region 23 may serve to provide an ohmic contact between the source node S and the respective body region 22, more specifically, between the body region 22 and a source metallization (not illustrated).

In the transistor device shown in Figures 2A and 2B, the compensation regions 21 of the transistor cells 10 are connected to the source node S. For this, the compensation region 21 of each transistor cell 10 adjoins the respective body region 22 in the vertical direction of the semiconductor body 100. In lateral directions, the compensation regions 21 are spaced apart from the gate trenches 30.

In the transistor device shown in Figures 2A and 2B, the transistor cells are arranged such that the semiconductor region forming the bias region 4 of two neighboring transistor cells 10 is located between the gate trenches of these transistor cells. Further, in this example, each transistor cell 10 includes a bias region 4. This, however, is only an example. According to another example (not shown), some of the bias regions 4 are omitted. In this case, neighboring transistor cells that each do not include a bias region may be implemented with a joint gate electrode.

Referring to Figure 2B, the transistor cells 10 may be elongated in a lateral direction that is perpendicular to the section plane illustrated in Figure 2A. Figure 2B shows a horizontal cross sectional view of the semiconductor body 100 in a section plane A-A shown in Figure 2A. In the following, a lateral direction x, which is a direction in which the body regions 22 adjoin the respective gate trenches 30 is referred to as first lateral direction x in the following. A lateral direction perpendicular to the first lateral direction x is referred to as second lateral direction y. Referring to Figure 2B, the transistor cells 10 may be elongated in the second lateral direction y. "Elongated" means, for example, that a dimension of the drift regions 11 (or compensation regions 21) in the second lateral direction y is at least one 100 (=1E2) times, or at least one 1000 (=1E3) times, the dimension of the drift regions 11 (or the compensation regions 21) in the first lateral direction x.

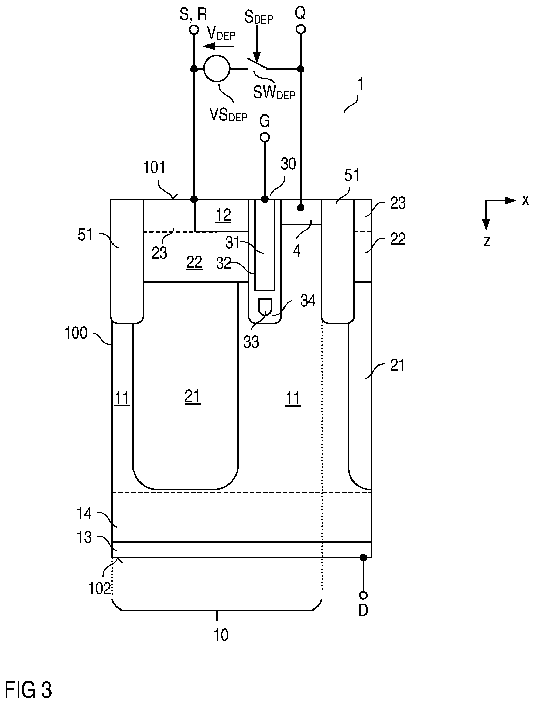

Figure 3 illustrates a modification of the transistor device shown in Figure 2. In the transistor device shown in Figure 3, the body region 22 of each transistor cell 10 (wherein only one transistor cell is shown in Figure 3) is arranged between a respective gate trench 30 and a first isolation trench 51. The compensation region 21 adjoins the body region 22, is spaced apart from the gate trench 30 and may adjoin the isolation trench 51. The bias region 4 of each transistor cell 10 is arranged between the gate trench 30 of the respective transistor cell 10 and the first isolation trench 51 of a neighbouring transistor cell (a section of the neighbouring transistor cell is illustrated in Figure 3).

Optionally, the transistor cell 10 further includes a field electrode 33. The field electrode 33 is arranged in the gate trench 30 below the gate electrode 31 (as seen from the first surface 101), is arranged adjacent to the drift region 11 and is dielectrically insulated from the drift region 11 by a field electrode dielectric 34. The field electrode dielectric 34 electrically insulates the field electrode 33 from the drift region 11. In a way not illustrated in detail in Figure 3, the field electrode 33 may be connected to the gate node G, the source node S or the bias node Q. The field electrodes 33 are useful to adjust a gate-drain capacitance of the transistor device, wherein the gate-drain capacitance is a capacitance between the gate node G and the drain node D of the transistor device. According to one example, the field electrode 33 is connected to the source node S to achieve a low gate-drain capacitance. According to another example, the field electrode 33 is connected to the gate node G to achieve a higher gate-drain capacitance.

The first isolation trench 51 is a trench extending from the first surface 101 into the semiconductor body 100 and electrically insulates the bias region 4 and the drift region 11 of one transistor cell from the body region 22 and the optional contact region 23 of a neighbouring transistor cell. The first isolation trench 51 may include any kind of electrically insulating material. Examples for implementing the first isolation trench 51 are explained in detail herein further below.

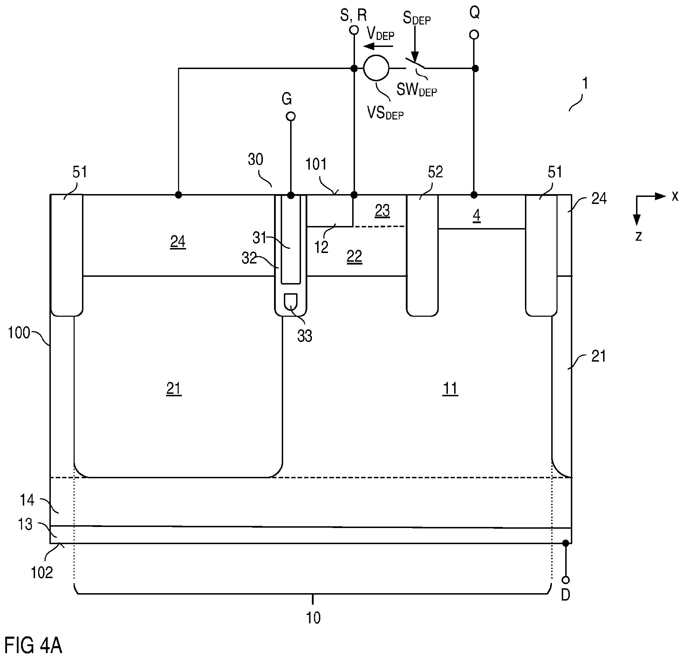

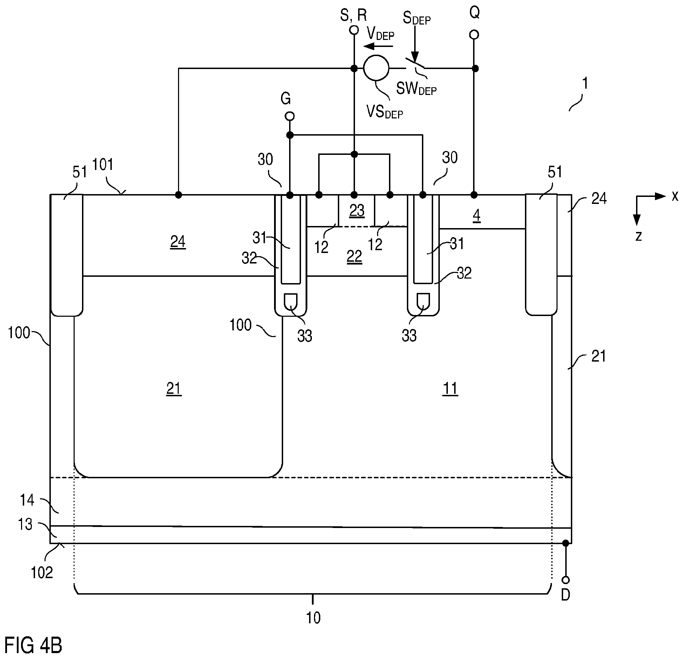

Figure 4A illustrates a modification of the transistor device shown in Figure 3. The transistor device shown in Figure 4 is different from the transistor device shown in Figure 3 in that the compensation region 21 is spaced apart from the body region 22. The compensation region 21 is either directly connected to the source node S or is connected to the source node S via a contact region 24 (as illustrated in Figure 4), wherein the contact region 24 adjoins the compensation region 21 and has a higher doping concentration than the compensation region 21. A doping concentration of the contact region 24 is high enough to obtain an ohmic contact between the contact region 24 and the source node S.

In the example shown in Figure 4A, at least one of the compensation region 21 and the contact region 24 may adjoin the gate trench 30 on one side, wherein the body region 22 and the source region 12 adjoin the gate trench 30 on another side opposite the at least one of the compensation region 21 and the contact region 24. The field electrode 33 in the gate trench 30 below the gate electrode 31 is optional and may be omitted.

Further, in the transistor device shown in Figure 4A, the bias region 4 is separated from the body region 22 (and the optional contact region 23) by a second isolation trench 52. The bias region 4 of one transistor cell is separated from the compensation region 21 and the optional contact region 24 of a neighbouring transistor cell by the first isolation trench 51.

Figure 4B illustrates a modification of the transistor device shown in Figure 4A. The transistor device shown in Figure 4B is different from the transistor device shown in Figure 4A in that it includes a further gate trench 30 instead of the second isolation trench 52 between the body region 22 and the bias region 4. Further, the transistor device shown in Figure 4B includes a further source region 12 connected to the source node S and adjoining the further gate trench 30.

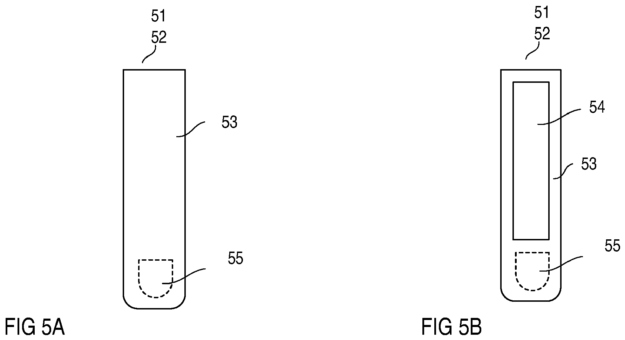

The first and second isolation trenches 51, 52 may be implemented in various ways. Two examples for implementing these isolation trenches 51, 52 are illustrated in Figures 5A and 5B. The first and second isolation trenches 51, 52 of one transistor cell 10 may be implemented in the same way or in different ways. In context with Figures 5A and 5B, "isolation trench" relates to any one of the first and second isolation trenches 51, 52.

According to one example illustrated in Figure 5A, the isolation trench 51, 52 may completely filled with an electrically insulating material 53. Examples of the electrically insulating material include an oxide, a nitride, or combinations thereof. According to another example illustrated in Figure 5B, a void 54 filled with air or a noble gas, for example, is arranged within the electrically insulating material 53.

Optionally, in the example illustrated in Figure 5A as well as in the example illustrated in Figure 5B, the isolation trench 51, 52 may include an electrode 55 in the region of a bottom of the isolation trench 51, 52. The electrode 55 is surrounded by the electrically insulating material 53 and may be connected to one of the gate node G, the source node S, or the bias node Q. An electric field along the first surface 101 in the bias region 4 and a current density in a region along the isolation trench 51 is dependent on to which of the circuit nodes (G, S, or Q) the field electrode 33 is connected to. According to one example, in the transistor device according to Figures 4A and 4B, the isolation trench 51 includes a field electrode 55 connected to the bias node Q.

In each of the examples explained above, the bias region 4 may be implemented as a doped semiconductor region of the second doping type. In this case, a pn-junction is formed between the bias region 4 and the drift region 11 in the examples explained above. This pn-junction prevents a current flow from the drain region 11 to the bias node Q when the transistor device is in the blocking state and the drain source-voltage V_{DS} increases. On the other hand, when the bias switch SW_{DEP} is switched on, a bias region 4 of the second doping type injects second type charge carriers (which are holes in an n-type transistor device) into the drift region 11 that flow via the compensation region 21 and/or the body region 22 to the bias voltage source VS_{DEP}. This current flow is associated with additional losses.

Such losses can be reduced by suitably selecting the doping concentration of the bias region 4. The bias region 4 can be considered as an emitter of a bipolar transistor formed by the bias region 4, the drift region 11 and the compensation and body regions 21, 22. According to one example, a doping concentration of the bias region 4 is less than 5E18 cm⁻³ to achieve a rather low efficiency of this emitter, that is, to suitably limit the amount of charge carriers injected into the drift region 21 by the emitter. According to one example, the doping concentration of the bias region 4 is between 1E16 cm⁻³ and 2E18 cm⁻³.

Furthermore, such losses can be widely prevented when implementing the bias region 4 as a doped region of the first doping type. Thus, in each of the examples explained above, the bias region 4 may be also implemented as a doped semiconductor region of the first doping type. A current flow between the drain region 11 and the bias node Q can be prevented in this case by switching of the bias switch SW_{DEP} in due time when the transistor device is in the blocking state and the drain source-voltage V_{DS} increases or by any other means that interrupt a current flow from the drain region 11 to the bias region 4 when the transistor device 1 is in the blocking state. These other means may include means that interrupt a current path below the bias region 4 in the mesa region between the trenches 30 or 51, 52.

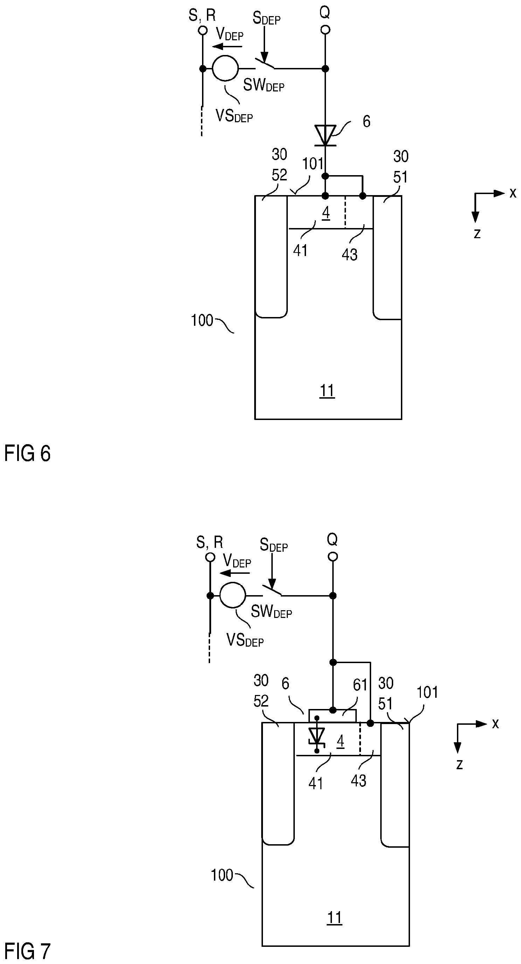

According to one example illustrated in Figure 6, the bias region 4 is a doped region 41 of the first doping type. In this example, a diode 6 may be connected between the bias region 4 and the bias voltage source VS_{DEP}. In Figure 6, only the circuit symbol of the diode 6 is illustrated. Examples for implementing this diode 6 are explained herein further below. The diode 6 helps to prevent a current flow between the drain node D (not illustrated in Figure 6) and the source node S via the drift region 11 and the bias region 4 when the transistor device is in the blocking state and the bias switch SW_{DEP} is switched on.

Figure 6 only illustrates the bias region 4 and two trenches between which the bias region 4 is located. These trenches may include two gate trenches 30 as illustrated in Figure 2A, a gate trench 30 and a first isolation trench 51 as illustrated in Figure 3 or a first isolation trench 51 and a second isolation trench 52 as illustrated in Figure 4. These trenches are only schematically illustrated in Figure 6 and may be implemented in accordance with any of the examples explained above.

Optionally, as illustrated in dashed lines in Figure 6 a doped region 43 of the second doping type is connected between the diode 4 and the drift region 11 and adjoins the bias region 4. This region 43 of the second doping type may be useful, in addition to the body region 22, to divert minority charge carriers from the drift region 11 when the transistor device changes from the diode state to the blocking state. The diode 6 may be any kind of external diode connected between the bias voltage source VS_{DEP} and the bias region 4.

According to one example illustrated in Figure 7, the diode 6 is a Schottky diode and is formed by the bias region 4 and a Schottky metal layer 61 adjoining the bias region 4. The Schottky metal layer 61 may include at least one of titanium (Ti), molybdenum (Mo), molybdenum silicide (MoSi), tantalum (Ta), titanium silicide (TiSi), or tantalum silicide (TaSi). The Schottky diode prevents a current flow from the drift region 11 to the bias node Q when the transistor device is in the blocking state and the drain-source voltage increases. This is similar to the example in which the bias region 4 is of the second doping type so that a pn-junction is formed between the bias region 4 and the drift region 11. Unlike a bias region 4 of the second doping type, however, the Schottky diode formed by the bias region 4 of the first doping type and the Schottky metal does not inject second type charge carriers into the drift region 11.

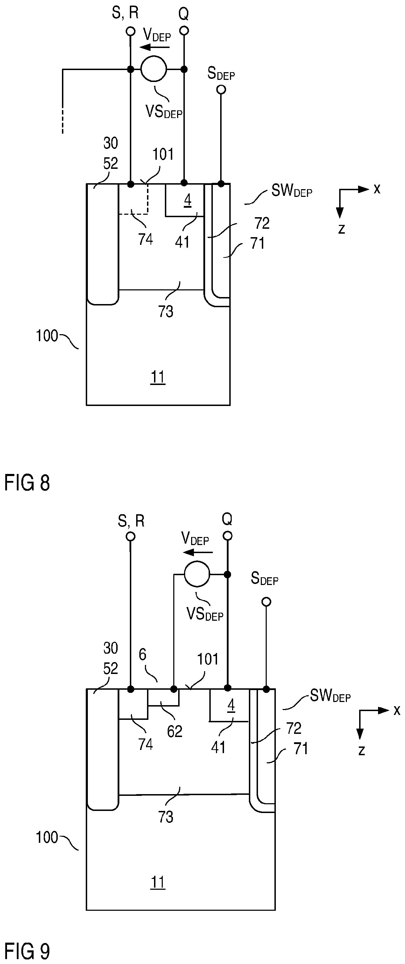

According to one example, the bias switch SW_{DEP} is integrated in the semiconductor body 100. Examples for integrating the bias switch SW_{DEP} in the semiconductor body 100 are explained with reference to Figures 8 to 10 in the following. In each of these examples, the bias switch SW_{DEP} includes an auxiliary MOSFET integrated in the semiconductor body 100.

In the example illustrated in Figure 8, the auxiliary MOSFET includes a gate electrode 71 arranged in a trench of the semiconductor body 100 and dielectrically insulated from semiconductor regions of the semiconductor body 100 by a gate dielectric 72. The bias region 4 is a region 41 of the first doping type and forms a first source or drain region of the auxiliary MOSFET. The drift region 11 forms a second source or drain region of the auxiliary MOSFET. A body region 73 of the second doping type is arranged between the bias region 4 and the drift region 11. Optionally, the source node S is connected to the body region 73, wherein an optional contact region 74 may provide for an ohmic contact between the source node S and the body region 73.

Figure 9 shows a modification of the arrangement shown in Figure 8. In the example illustrated in Figure 9, the diode 6 is also integrated in the semiconductor body 100. In this example, the diode 6 is formed by a pn-junction between the contact region 74 of the second doping type, which is also referred to as first diode region in the following, and a second diode region 62 of the first doping type. The bias voltage source VS_{DEP} is connected between the second diode region 62 and the bias region 4 in this example. In each of the examples illustrated in Figures 8 and 9, the auxiliary MOSFET of the bias switch SW_{DEP} is a MOSFET of the first conductivity type.

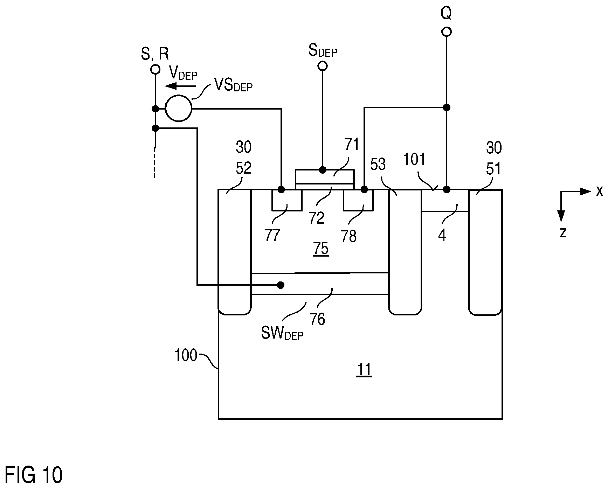

Figure 10 illustrates another example of the bias switch SW_{DEP}. In this example, the auxiliary MOSFET of the bias switch SW_{DEP} is a lateral MOSFET. The gate electrode 71 is arranged on top of the first surface 101 of the semiconductor body 100 and is dielectrically insulated from the semiconductor body 100 by the gate dielectric 72. The MOSFET is of the second conductivity type in this example and includes a body region 75 of the first doping type and source and drain regions 77, 78 of the second doping type. These source and drain regions 77, 78 are spaced apart from each other in a lateral direction of the semiconductor body 100. One of the source and drain regions 77, 78 is connected to the bias voltage source VS_{DEP}. The other one of the source and drain regions 77, 78 is connected to the bias region 4, wherein the bias region 4 is separated from the semiconductor regions of the bias switch SW_{DEP} by a third isolation trench 53. This third isolation trench 53 may be implemented in accordance with one of the examples illustrated in Figures 5A and 5B.

Referring to Figure 10, a junction region 76 of the second conductivity type forms a junction isolation between the body region 75 of the auxiliary MOSFET and the drift region 11. This junction region 76 extends from the gate trench 30 or the second isolation trench 52 on one side to the third isolation trench 53 on the other side. The junction region 76 is connected to the source node, for example. A connection between the junction region 76 and the source node S is only schematically illustrated in Figure 10.

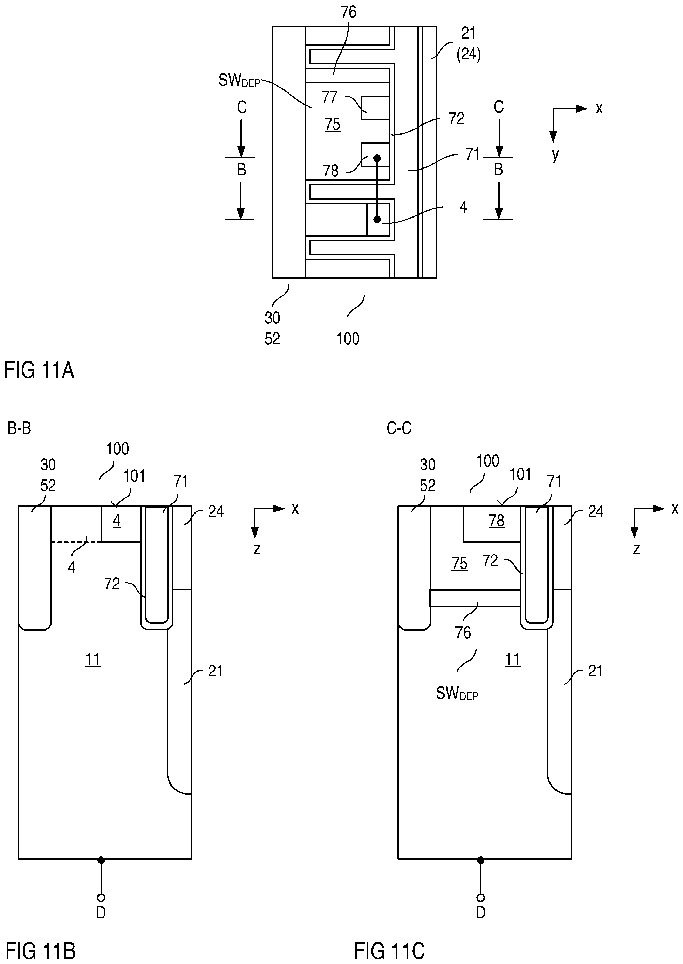

In the example illustrated in Figure 10, the source and drain regions 77, 78 of the auxiliary MOSFET of the bias switch SW_{DEP} are spaced apart from each other in the first lateral direction x and the bias region 4 is spaced apart from the semiconductor regions forming the bias switch SW_{DEP} in the first lateral direction x. This, however, is only an example. Figures 11A to 11C illustrate a modification of the transistor arrangement shown in Figure 10, wherein Figure 11A shows a horizontal cross sectional view of a section of the semiconductor body 100 in which the bias switch SW_{DEP} and the bias region 4 are integrated, Figure 11B shows a vertical cross sectional view of a section in which the bias region 4 is integrated, and Figure 11C shows a vertical cross sectional view of a section in which one of the source and drain regions 77, 78 of the bias switch SW_{DEP} is integrated.

In the example illustrated in Figures 11A to 11C, the gate trench with the gate electrode 71 and the gate dielectric 72, in the horizontal cross sectional view, has the shape of a comb with fingers that, in the first lateral direction x, each extend to the gate trench 30 or the second isolation trench 52 of the transistor cell 10. Between two of these fingers of the gate structure 71, 72 the bias region 4 is arranged, and between two of these fingers the source and drain regions 77, 78, the body region 75 and the junction region 76 of the bias switch SW_{DEP} are arranged. The source and drain regions 77, 78 adjoin the gate dielectric 72 and are arranged spaced apart from each other in the second lateral direction y, that is, the direction that is essentially parallel to the longitudinal direction of the gate trench 70 or the second isolation trench 52. The bias region 4 is spaced apart from the semiconductor regions forming the bias switch SW_{DEP} in the second lateral direction y.

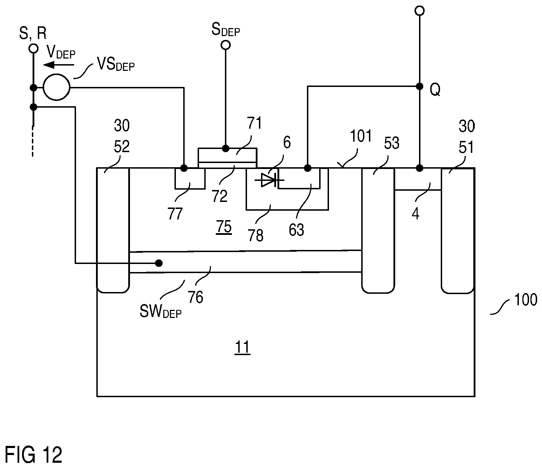

Figure 12 shows a modification of the arrangement shown in Figure 10. In the example shown in Figure 12, the diode 6 is integrated in the semiconductor body 100. More specifically, drain or source region 78 of the bias switch SW_{DEP} forms a first diode region and a second diode region 63 of the first doping type, which is a doping type complementary to the doping type of the source or drain region 78, is embedded in the source or drain region 78. The diode is formed by the pn-junction between the source or drain region 78 and the second diode region 63. The second diode region 63 is connected to the bias region 4.

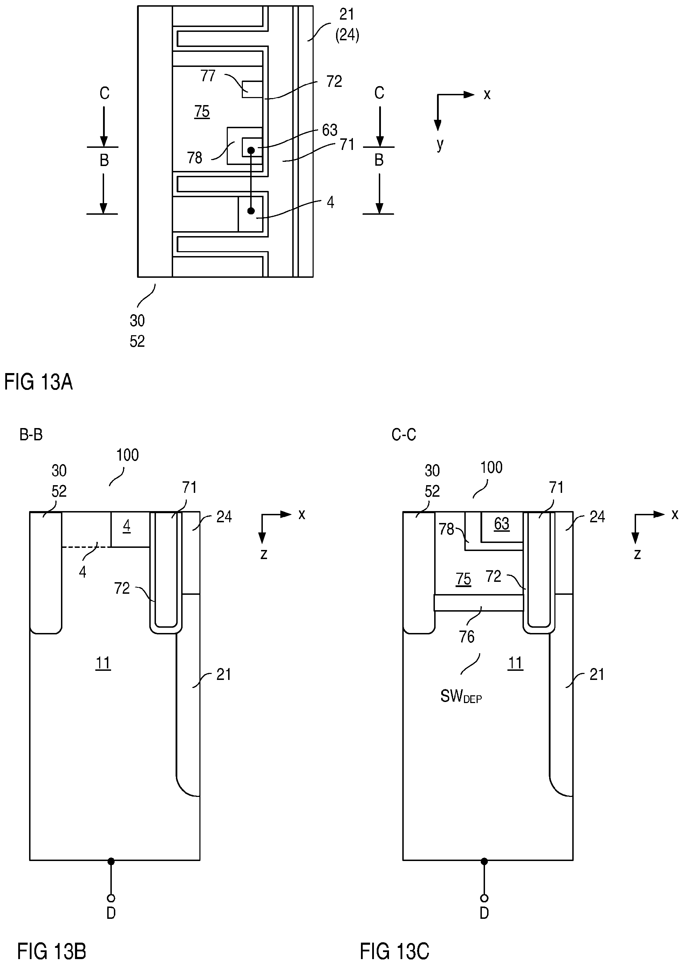

Figures 13A to 13C illustrate a modification of the arrangement shown in Figures 11A to 11C. The arrangement shown in Figures 13A to 13C is different from the arrangement shown in Figures 11A to 11C in that the diode 6 is integrated in the semiconductor body 100. For this, like in the example illustrated in Figure 12, the second diode region 63 is embedded in the source or drain region 78 and connected to the bias region 4.

In the examples illustrated in Figures 10, 11A to 11C, 12 and 13A to 13C, connections between the source or drain region 78 or the second diode region 63 and the bias region 4 are only schematically illustrated. These connections may be implemented in a conventional way using metallizations formed on top of the first surface 101 of the semiconductor body 100.

Figure 14 illustrates one example of an electronic circuit in which a transistor arrangement 1 of the type explained above may be used as a rectifier element. In this example, the load path D-S of the superjunction transistor device included in the transistor arrangement 1 is connected in series with an electronic switch SW so that a half-bridge is formed by the superjunction transistor device and the electronic switch SW. The superjunction transistor device is referred to as TSJ in the following. Any type of electronic switch, e.g. another transistor arrangement of the same type as transistor arrangement 1, can be used as the electronic switch SW. A series circuit including the electronic switch SW and the transistor arrangement 1 is connected between a first supply node and a second supply node, wherein a supply voltage V_{SUP} is available between these supply nodes. Further, an inductive load Z (that is, a load that includes at least one inductor L) is connected in parallel with the drain-source path D-S of the transistor device of the transistor arrangement 1. In this type of circuit arrangement, the electronic switch SW serves as an electronic switch that connects the load Z to the supply voltage V_{SUP} dependent on a drive signal Ssw received by the electronic switch SW. The transistor arrangement 1 acts as a rectifier element (or freewheeling element) that takes over a current from the inductive load Z when the switch SW switches off.

The transistor arrangement 1 may be operated as a passive rectifier element, so that the superjunction transistor device TSJ only changes between the diode state and the blocking state. The superjunction transistor device TSJ changes to the diode state when the electronic switch SW switches off and the inductive load Z reverse biases the superjunction transistor device of the transistor arrangement 1. When the electronic switch SW again switches on, the electronic switch SW takes over the load current I_{L} and the superjunction transistor device TSJ changes to the blocking state. Operating the transistor arrangement 1 in this way is explained below with reference to Figure 15.

Figure 15 shows signal diagrams that illustrate one example of operating the electronic circuit shown in Figure 14. More specifically, Figure 15 shows signal waveforms of the drain-source voltage V_{DS}, the gate-source voltage V_{GS}, a control signal Ssw of the switch SW connected in series with the transistor arrangement 1, and a control signal S_{DEP} of the bias switch SW_{DEP} connected in series with the bias voltage source VS_{DEP}. Each of the control signals Ssw, S_{DEP} can have an on-level that switches on the respective switch SW, SW_{DEP}, or an off-level that switches off the respective switch SW, SW_{DEP}. Just for the purpose of illustration, the on-level is a logic high signal level and the off-level is a logic low signal level in this example.

In the example illustrated in Figure 15, the transistor arrangement 1 is operated such that the gate-source voltage V_{GS} of the superjunction transistor device TSJ is always below the threshold voltage so that the superjunction transistor device TSJ either operates in the diode state (the third operating state) or the blocking state (the fourth operating state). Just for the purpose of explanation it is assumed that the gate-source voltage V_{GS} is zero in this example. In this case, the operating state of the superjunction transistor device TSJ is only governed by the switch SW.

Referring to Figure 15, the switch SW connected in series with the transistor arrangement 1 is switched on before a first time instance 11. Thus, a voltage across the load Z, which equals the drain-source voltage V_{DS} of the transistor arrangement 1, essentially equals the supply voltage V_{SUP} and the superjunction transistor device TSJ of the transistor arrangement 1 is in the blocking state. When the switch SW is in the on-state, a load current I_{L} flows through the inductive load Z as indicated in Figure 14.

When the switch SW switches off at the first time instance 11, a commutation process starts, In this commutation process, the inductive load Z forces the load current I_{L} to flow through the transistor arrangement 1, that is, the inductive load Z reverse biases the superjunction transistor device TSJ and operates the superjunction transistor device TSJ in the diode state. Referring to Figure 15, the superjunction transistor device is not immediately reverse biased at the first time instance 11, but there is a transient phase between the first time instance t1 and a time instance t11 after the first time instance. In the transient phase, the operating state of the superjunction transistor device changes from the blocking state (fourth operating state) to the diode state (third operating state). During this transient phase, the drain-source voltage V_{DS} changes its polarity. Referring to Figure 15, when the electronic switch SW again switches on at a second time instance t2 (which is after the first time instance 11), the superjunction transistor device TSJ becomes forward biased and enters the blocking state so that the drain-source voltage V_{DS} again increases to a voltage level that essentially equals the supply voltage level V_{SUP}. More specifically, there is a transient phase between the second time instance t2 and a time instance t21 after the second time instance t2. In this transient phase, the superjunction transistor device TSJ changes from the diode state (third operating state) to the blocking state (fourth operating state). During this transient phase, the drain-source voltage V_{DS} again changes its polarity.

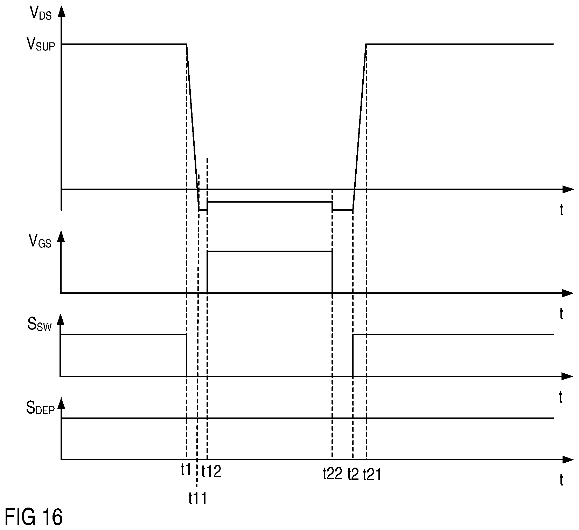

Figure 16 illustrates a modification of the drive scheme illustrated in Figure 15. In the example illustrated in Figure 16, the superjunction transistor device TSJ is operated in the reverse conducting state (the second operating state) after switching off the switch SW at the first time instance t1 and before again switching on the switch SW at the second time instance t2. More specifically, there is a first dead time between the first time instance t1 and a time instance 112 when the superjunction transistor device is switched on in order to operate in the reverse conducting state, wherein this dead time may be longer than the transient phase between t1 and t1 1 explained above. Further, there is a dead time between a time instance t22 at which the superjunction transistor device is switched off and the second time instance t2 at which the switch SW again switches on. During these dead times, the superjunction transistor device operates in the diode state including the above referenced transient phases. Referring to Figure 16, a magnitude of the drain-source voltage V_{DS} may be lower in the reverse conducting state than in the diode state. Thus, operating the superjunction transistor device in the reverse conducting state may help to reduce conduction losses when the superjunction transistor device conducts the load current I_{L}.

In each of the operating scenarios illustrated in Figures 15 and 16 there are transient phases in which the superjunction transistor device TSJ of the transistor arrangement 1 changes from the diode state to the blocking state. By applying the bias voltage V_{DEP} between the compensation regions 21 of the transistor cells 10 (not shown in Figure 14) and the bias regions 4 (also not shown in Figure 14) at least during the transient phase between the diode state and the blocking state losses associated with this transition can be reduced as explained in the following.

For explanation purposes it is assumed that the bias voltage source VS_{DEP} and the bias switch SW_{DEP} are omitted or that the bias switch SW_{DEP} is permanently open. In this case, the transistor arrangement 1 operates like a conventional transistor. Thus, when the transistor device changes from the diode state to the blocking state the current associated with this transition (that is, the current associated with removing the charge carrier plasma and forming the depletion region) is not absorbed by the depletion voltage source, but flows through a current path that includes the load paths of the transistor device and the electronic switch SW. The voltage across this current path equals the supply voltage V_{SUP}. This supply voltage V_{SUP} is selected dependent on the requirements of the load Z and may be several hundred volts such as between 400V and 1000V. According to one example, the supply voltage is between 50% and 90% of the voltage blocking capabilities of the devices SW, 1 in the half-bridge.

The bias voltage V_{DEP} can be adjusted independent of the requirements of the load Z and, as explained above, can be as low as several volts. Thus removing the charge carrier plasma and forming the depletion region governed by the bias voltage V_{DEP} results in much lower losses than removing the charge carrier plasma and forming the depletion region governed by the supply voltage V_{SUP}. Thus, using a transistor arrangement 1 explained above instead of a conventional superjunction transistor may help to significantly reduce commutation losses.

Referring to the above, the bias voltage V_{DEP} between the bias node Q and the drift region 11 removes charge carriers from the charge carrier plasma and causes the junction capacitances to be charged (that is, causes a depletion region to expand in the drift region 11 and the compensation region 21). The junction capacitance may further be charged as the load path voltage V_{DS} increases to voltage levels higher than the bias voltage V_{DEP}. The current associated with this further charging of the junction capacitance does not flow with the bias node Q but flows via the drain and source nodes D, S of the superjunction transistor device so that the losses associated with this current are essentially given by the current level multiplied with the supply voltage V_{SUP}, which may be significantly higher than the bias voltage V_{DEP}. In a superjunction transistor device, however, a capacitance value of the junction capacitance is not linearly on the voltage and significantly decreases as the voltage increases. In an modern superjunction transistor device with a voltage blocking capability of 800V such as Infineon's IPD80R900P7, for example, the capacitance decreases by about two orders of magnitude as the voltage across the junction capacitance increases between about 20V and about 30V. Thus, using the bias voltage V_{DEP} the junction capacitance can be pre-charged to a significant extent causing significant lower losses than charging the junction capacitance via the load path as usual.

Applying the bias voltage V_{DEP} between the bias region 4 and the compensation region 21 when the superjunction transistor TSJ is not in a transient phase between the diode state and the blocking state may cause losses. Thus, according to one example the bias voltage V_{DEP} is only applied for a rather short time that covers the transient phase. According to one example, applying the bias voltage V_{DEP} starts when the switch SW switches off, or several nanoseconds before the switch SW switches off, and ends when the drain-source voltage V_{DS} of the superjunction transistor TSJ has reached a predefined threshold.

In the examples explained before, the compensation region 21 is directly connected to the source node S. Thus, when the transistor device is in the reverse conducting state or the diode state and the bias voltage source VS_{DEP} is connected between the bias region 4 and the compensation region 21, the current between the drain node D and the source node S partially flows via the bias voltage source VS_{DEP}. The bias voltage source VS_{DEP}, therefore, has to be adapted to carry the load current in this example.

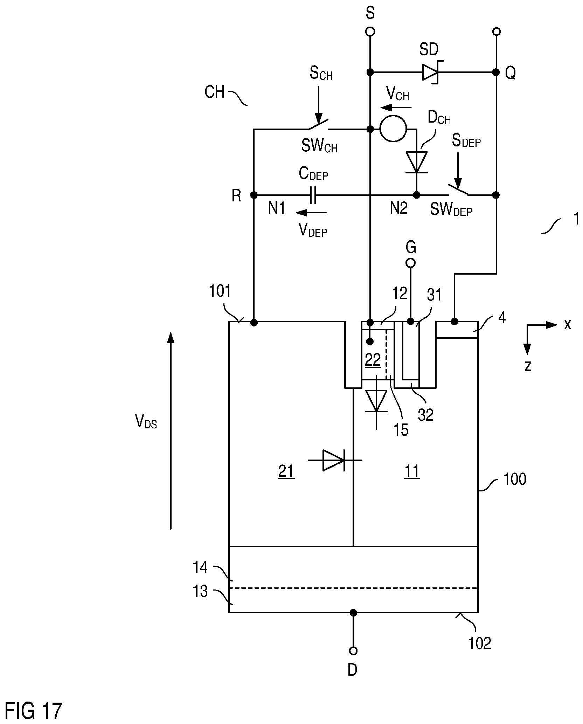

Figure 17 illustrates a modification of the transistor arrangement 1 shown in Figure 1 in which a current flow via the bias voltage source VS_{DEP} is prevented when the transistor device is either in the diode state or the reverse conducting state.

The transistor arrangement shown in Figure 17 is different from the transistor arrangement shown in Figure 1 in that the bias voltage V_{DEP} is provided by a capacitor C_{DEP} connected between the bias region 4 and the compensation region 21. This capacitor C_{DEP} is also referred to as bias capacitor in the following. The bias switch SW_{DEP} is represented by its circuit symbol in Figure 17. This bias switch SW_{DEP} may be implemented as an external device or may be integrated in the semiconductor body 100 in accordance with any of the examples explained herein before.

Referring to Figure 17, the transistor arrangement 1 further includes a charging circuit CH for charging the capacitor C_{DEP}. The charging circuit CH includes a charging voltage source configured to provide a charging voltage V_{CH} and a switch S_{CH} connected in series with the charging voltage source. A series circuit including the voltage source and the switch S_{CH} is connected in parallel with the bias capacitor C_{DEP}. A circuit node between the charging voltage source and the switch S_{CH} is connected to the source node S, so that the switch S_{CH} is connected between the source node S and a first node N1 of the bias capacitor C_{DEP} and the voltage source is connected between the source node S and a second node N2 of the bias capacitor C_{DEP}. In this way, the electrical potential at the second node N2 of the bias capacitor C_{DEP} is kept at a predefined voltage level, wherein this voltage level is essentially given by the electrical potential at the source node S and the charging voltage V_{CH}. The first node N1 of the bias capacitor C_{DEP} which is connected to the compensation region 21 is also referred to as second bias node R in the following.

According to one example, the charging switch SW_{CH} is operated in such a way that it is in the on-state to charge the bias capacitor C_{DEP} when the superjunction transistor device is in the forward conducting state or the reverse conducting state and in the off-state when the superjunction transistor device is in the diode state or the blocking state. In this way, a connection between the compensation region 21 and the source node S is interrupted when the transistor device is in the diode state. The bias voltage V_{DEP} is provide by the bias capacitor C_{DEP} via the bias switch SW_{DEP}. The bias switch SW_{DEP} may be operated in the same way as explained above. That is, the bias switch SW_{DEP} is switched on at least during a transient phase between the diode state and the blocking state and may be switched on throughout the diode state and the blocking state.

Optionally, a rectifier element D_{CH} such as a diode is connected between the charging voltage source and the second node N2 of the bias capacitor C_{DEP}. This rectifier element is connected such that it prevents a current flow from the bias region 4 via the bias switch SW_{DEP} and the voltage source to the source node S.

Optionally, a further rectifier element SD is connected between the source node S and the bias region 4. According to one example, this rectifier element SD is a Schottky diode. This rectifier element serves to limit a voltage between the source node S and the bias region 4 to a threshold level that is given by the forward voltage of the rectifier element SD. Alternatively (not illustrated) the optional further rectifier element is connected between the source node S and the circuit node between the bias capacitor C_{DEP} and the bias switch SW_{DEP}.

The circuit topology illustrated in Figure 17 with the charging capacitor C_{DEP}, the charging circuit CH and the optional rectifier element SD can be implemented in each of the transistor arrangements explained above. That is, the superjunction transistor device can be implemented in accordance with any of the superjunction transistor devices explained herein before.

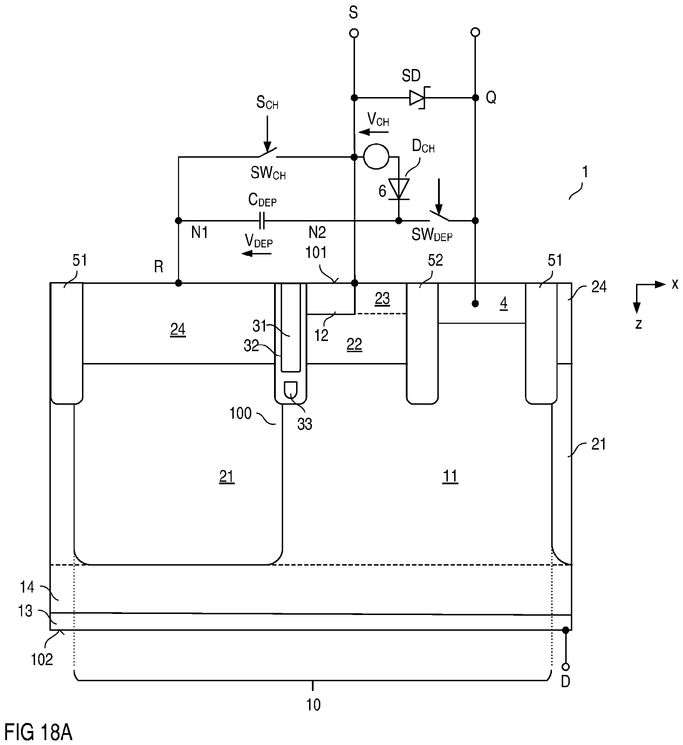

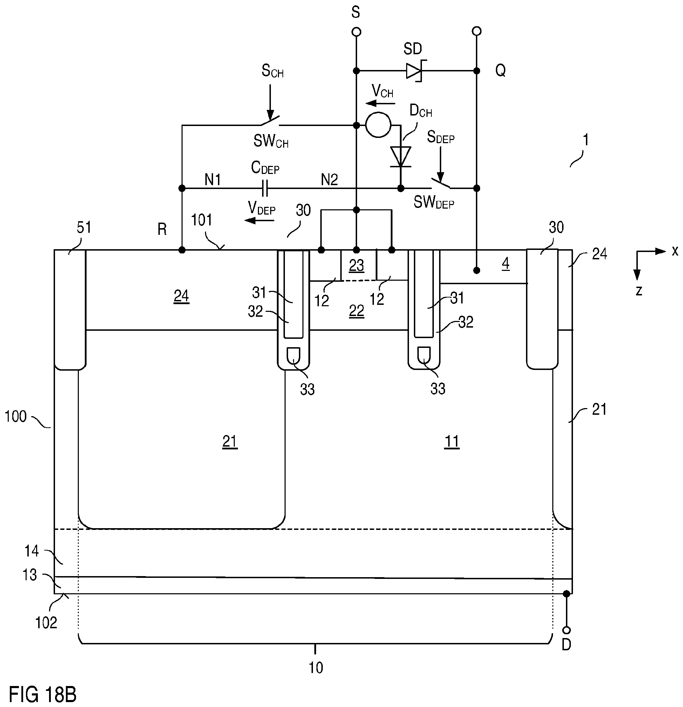

Figure 18A, for example, shows a transistor arrangement of the type shown in Figure 17 that includes a transistor arrangement of the type shown in Figure 4A. Figure 18B shows a transistor arrangement of the type shown in Figure 14 that includes a transistor device of the type shown in Figure 4B.

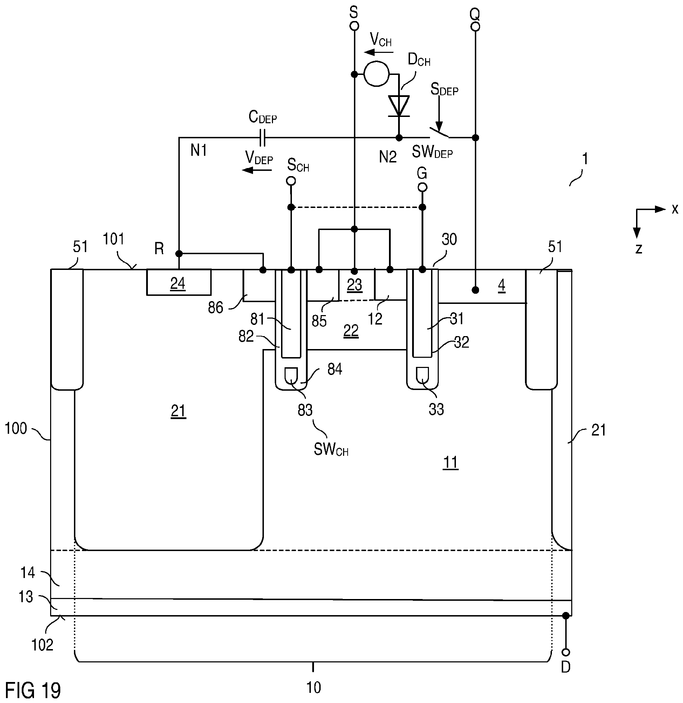

According to one example, the charging switch SW_{CH} is integrated in the semiconductor body 100. One example of a transistor arrangement 1 in which the charging switch S_{CH} is integrated in the semiconductor body 100 is illustrated in Figure 19. In this example, the charging switch SW_{CH} includes a MOSFET with a gate electrode 81 and a gate dielectric 82 that are arranged in a trench between the body region 22 and the compensation region 21. The trench with the gate electrode 81 and the gate dielectric 82 extends from the first surface 101 adjacent to the body region 22 and a section of the compensation region 21 into the drift region 11. A first source or drain region 85 of the MOSFET is arranged in the body region 22, connected to the source node S and adjoins the trench with the gate electrode 81 and the gate dielectric 82 on one side. A second source or drain region 86 is connected to the first node N1 of the bias capacitor C_{DEP}, adjoins the trench with the gate electrode 81 and the gate dielectric 82 on a side opposite the side of the first source or drain region 85 and is arranged in the compensation region 21. The MOSFET forming the charging switch SW_{CH} switches on or of dependent on a drive signal S_{CH} received at the gate electrode 81. In the on-state of the MOSFET there is a conducting channel in the body region 22 between the first source or drain region 85 and the drift region 11 and another conducting channel in the compensation region 21 between the drift region 11 and the second source or drain region 86, so that in the on-state of the MOSFET there is a conducting channel between the first and second source or drain regions 85, 86. Thus, the source node S is connected to the second bias node R.

According to one example (illustrated by a dashed line in Figure 19), the gate electrode 81 of the charging switch SW_{CH} is connected to the gate node G. In this case, the charging switch SW_{CH} is switched on whenever the transistor device is in an on-state, that is, whenever the transistor device is in the forward conducting state or the reverse conducting state. Thus, the bias capacitor C_{DEP} is charged each time the transistor device is in the on-state. Further, in this case, each time the transistor device switches on, the charging switch SW_{CH} connects the compensation region 21 to the source node S and, therefore, causes the compensation region 21 to be discharged when the transistor device changes from the blocking state into the forward conducting state, for example. Such discharging of the compensation region 21 is useful to achieve a low on-resistance in the forward conducting state of the transistor device.

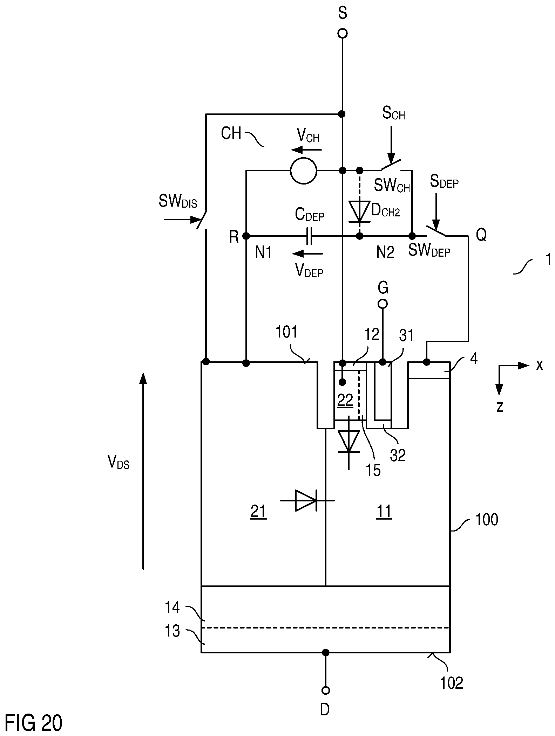

Figure 20 illustrates a modification of the transistor arrangement 1 shown in Figure 17. In the transistor arrangement 1 according to Figure 20, the charging voltage source is connected between the source node S and the second bias node R, which is connected to the compensation region 21. The charging switch S_{CH} is connected between the source node S and the second circuit node N2 of the bias capacitor C_{DEP}. Further, the transistor arrangement 1 includes a discharging switch SW_{DIS} connected between the compensation region 21 and the source node S The bias switch SW_{DEP} is connected between the bias region 4 and the second circuit node N2 of the bias capacitor C_{DEP}.

When the transistor device is in the blocking state the junction capacitance formed by the drift region 11 and the compensation region 21 is charged. Via the discharging switch SW_{DIS} the junction capacitance, more specifically, the compensation region 21 can be discharged when the transistor device changes from the blocking state to the forward conducting state. Otherwise the on-resistance would be relatively high. According to one example, the discharging switch SW_{DIS} is operated synchronously with the transistor device such that the discharging switch SW_{DIS} switches on each time the transistor device switches on to operate in the forward conducting state or the reverse conducting state, and such that the discharging switch SW_{DIS} switches off when the transistor device is in the diode state or the reverse conducting state. According to one example, the charging switch SW_{CH} only switches on in order to charge the capacitor C_{DEP} when the discharging switch SW_{DIS} is switched off. The charging switch SW_{CH} may be operated complementarily to the discharging switch SW_{DIS}, so that the charging switch SW_{CH} switches on when the discharging switch SW_{DIS} switches off and switches off when the discharging switch SW_{DIS} switches on.

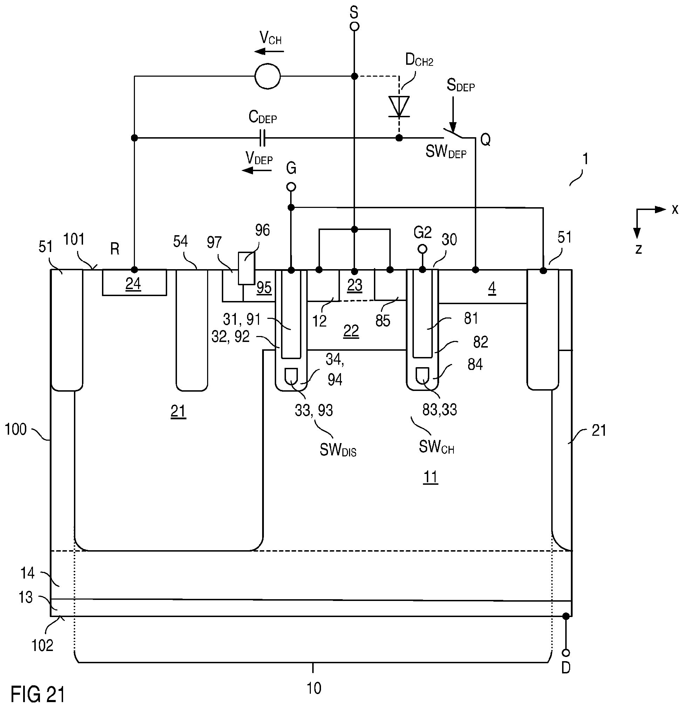

Figure 21 shows a vertical cross sectional view of an arrangement of the type shown in Figure 20, wherein the charging switch SW_{CH} and the discharging switch SW_{DIS} are integrated in the semiconductor body 100. Each of these switches SW_{CH}, SW_{DIS} is implemented as a MOSFET and includes a respective gate electrode 81, 91 connected to the gate node G of the superjunction transistor device so that operation of these switches SW_{CH}, SW_{DIS} is synchronized with operation of the superjunction transistor device. The discharging switch SW_{DIS} may be implemented such that it switches on and off synchronized with the superjunction transistor device so that this switch SW_{DIS} is in the on-state whenever the superjunction transistor device is in the forward conducting or the reverse conducting state. Referring to the above, the charging switch SW_{CH} may be operated such that it only switches on in order to charge the capacitor C_{DEP} when the discharging switch SW_{DIS} is switched off. Thus, in the example illustrated in Figure 21, the gate electrode 81 of the charging switch SW_{CH} is connected to a control node G2 that is different from the gate node G, wherein the gate electrode of the discharging switch SW_{DIS} is connected to the gate node G.

According to another example (not illustrated) the gate electrode 91 of the discharging switch SW_{DIS} is connected to a control node that is different from the gate node G. The gate electrode 91 of the discharging switch SW_{DIS} may be implemented in this way in addition to connecting the gate electrode 81 of the charging switch SW_{CH} to the gate node G2 so that the gate electrodes 81, 91 of the charging switch SW_{CH} and the discharging switch SW_{DIS} are connected to different control nodes. Alternatively, the gate electrode of the charging switch SW_{CH} is connected to the gate node G and the gate electrode 91 of the discharging switch SW_{DIS} is connected to a control node different from the gate node G.

In the arrangement shown in Figure 21, the charging switch SW_{CH} is implemented as explained with reference to Figure 19, wherein the gate electrode 81 of the charging switch SW_{CH} and one gate electrode 31 of the of the superjunction transistor device are formed by the same gate electrode. Furthermore, the gate electrode of the charging switch SW_{CH} is arranged between the bias region 4 and the body region 22.

The gate electrode 91 of the discharging switch SW_{DIS} and one gate electrode 31 of the of the superjunction transistor device connected to different gate electrodes G G2. Furthermore, the gate electrode of the discharging switch SW_{DIS} is arranged between the body region 22 and the compensation region 21. The discharging switch SW_{DIS} is a MOSFET of the first conductivity type, and includes a source region 95 of the first doping type, wherein the source region 95 is embedded in the compensation region 21 and adjoins the trench with the gate electrode 91. A body region of the discharging switch SW_{DIS} is formed by a section of the compensation region 21 that adjoins the gate trench, and a drain region of the discharging switch SW_{DIS} is formed by the drift region of the superjunction transistor device.

The discharging switch SW_{DIS} further includes a charge carrier converter that is configured to "convert" a second type charge carrier current provided by the compensation region 21 into a first type charge carrier current that can be conducted by the discharging switch SW_{DIS} to the drift region 11 in order to discharge the compensation region 21. The charge carrier converter includes the source region 95, a metal 96 adjoining the source region 95, and a region 97 of the second doping type. The region of the second doping type adjoins the metal and may adjoin the source region 95. The region of the second doping type 97 is embedded in the compensation region 21 and has a doping concentration that is higher than the doping concentration of the compensation region 21.

Optionally, an isolation trench 54 is arranged between the charge carrier converter 95, 96, 97 and the contact region 24 of the compensation region. This isolation trench 54 may be implemented in accordance with any of the examples explained with regard to isolation trenches 51, 52 herein above.

In the examples explained before, the gate electrodes 31 of the transistor cells 10 of the superjunction transistor are arranged in trenches of the semiconductor body 100. This, however, is only an example, it is also possible to implement the gate electrodes 31 as planar gate electrodes on top of the semiconductor body 100, although this is not illustrated in the drawings.

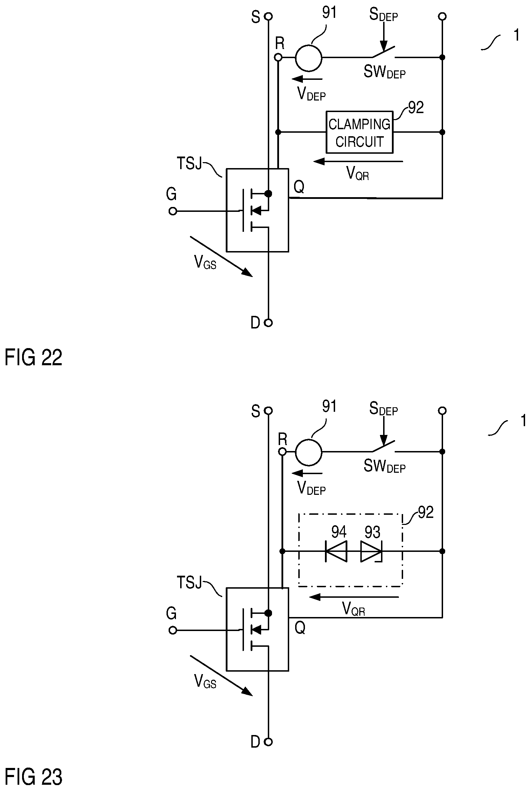

Figure 22 illustrates a circuit diagram of a transistor arrangement 1 according to a further example. This transistor arrangement includes a superjunction transistor device TSJ, wherein this superjunction transistor device TSJ can be implemented in accordance with any of the examples explained herein before. Like in the transistor arrangements explained before, a series circuit including a bias switch SW_{DEP} and a bias voltage source 91 is connected between the bias node Q and the further bias node R of the superjunction transistor device TSJ. As explained herein above, the further bias node R may be connected to the source node S or may be separated from the source node S. The bias voltage source 91 may be implemented in accordance with any of the examples explained before. That is, the bias voltage source 91 may be implemented as a constant voltage source VS_{DEP} or may be implemented using a capacitor C_{DEP} and at least an auxiliary voltage source.

Referring to Figure 22, the transistor arrangement 1 further includes a clamping circuit 92 connected between the bias node Q and the further bias node R. The clamping circuit 92 is configured to clamp a voltage V_{QR} between the bias node Q and the further bias node R such that a voltage level of this voltage V_{QR} does not exceed a clamping voltage level defined by the clamping circuit 92.

One example of the clamping circuit 92 is illustrated in Figure 23. In this example, the clamping circuit 92 includes at least one Zener diode 93 coupled between the bias node Q and the further bias node R. Optionally, a further diode 94 may be connected in series to the at least one Zener diode 93 such that the further diode 94 and the at least one Zener diode 93 are connected in a back-to-back configuration.

In the clamping circuit 92 of the type illustrated in Figure 23, the clamping voltage level is essentially defined by the Zener voltage of the at least one Zener diode 93. Although only one Zener diode 93 is illustrated in Figure 23, it goes without saying that two or more Zener diodes may be connected in series in order to suitably adjust the clamping voltage level. In a series circuit with several Zener diodes the Zener voltage of the series circuit is essentially given by the sum of the Zener voltages of the Zener diodes connected in series.

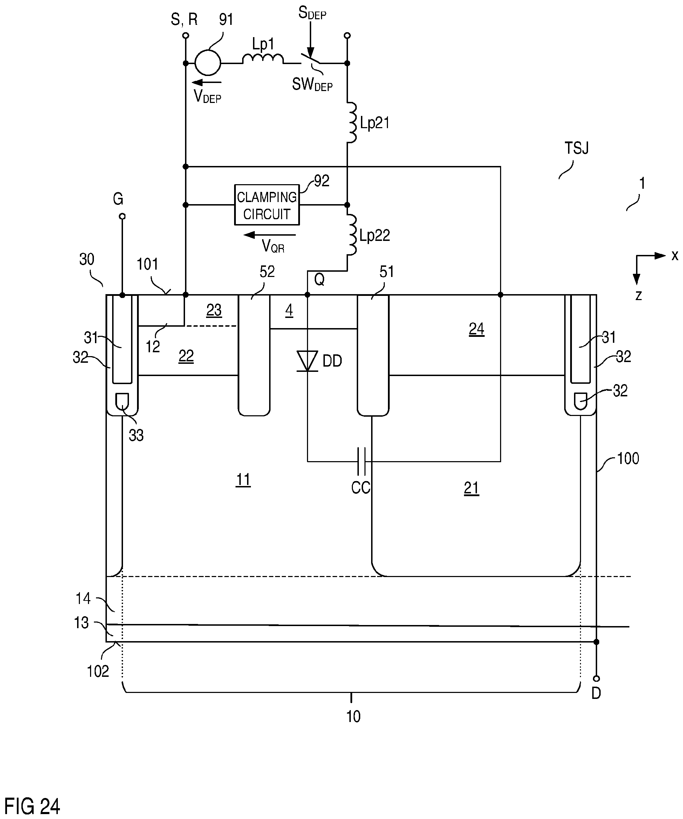

The function of the clamping circuit 92 in the transistor arrangement 1 is explained with reference to Figure 23 in the following. In Figure 24, a vertical cross sectional view of one section of the superjunction transistor device TSJ is illustrated in greater detail. Just for the purpose of illustration, the superjunction transistor device TSJ shown in Figure 24 is implemented in accordance with the example illustrated in Figure 4A. This, however, is only an example. The superjunction transistor device TSJ may be implemented in accordance with any of the other examples explained herein before as well.

Referring to Figure 24, inside the superjunction transistor device TSJ the bias node Q is coupled to the further bias node R via a diode DD and a capacitor CC. The diode DD may be formed (a) by a pn-junction between the bias region 4 and the drift region 11 when the bias region 4 has a doping type complementary to the doping type of the drift region 11; (b) by a Schottky diode of the type illustrated in Figure 7; or (c) by an external diode 6 of the type illustrated in Figure 6. The capacitor CC is formed by the junction capacitance between the drift region 11 and the compensation region 21.

For the purpose of illustration it is assumed that the superjunction transistor device TSJ is in an operating state in which the junction capacitance CC is essentially discharged. This is the case, for example, when the transistor device is in the forward conducting state. When the bias switch SW_{DEP} is closed, the junction capacitance CC is charged by the bias voltage source 91 via the diode DD. Charging the junction capacitance CC is associated with a current flow from the bias voltage source 91 via the bias region 4, the drift region 11, and the compensation region 21.

The connection lines between the bias voltage source 91 and the superjunction transistor device TSJ in the semiconductor body may include parasitic inductances. Such parasitic inductances are represented by inductors Lp1, Lp21, Lp22 in Figure 24. When a current flows through the connection lines so that the junction capacitance CC is charged and energy is stored in the junction capacitance energy is also stored in the parasitic inductances Lp1, Lp21, Lp22. The energy stored in the parasitic inductances Lp1, Lp21, Lp22 may have the effect that, after the voltage between the bias node Q and the further bias node R has reached the voltage level of the bias voltage V_{DEP}, the current continues to flow and further charges the junction capacitance CC. Thus, the voltage V_{SQ} between the bias node Q and the further bias node R may become higher than the voltage level of the bias voltage V_{DEP}. The overall parasitic inductance is between 1 nH and 10nH, for example.

Such increase of the voltage V_{QR} between the bias node Q and the further bias node R to voltage levels higher than the voltage level of the bias voltage V_{DEP} may be undesirable. The clamping circuit 92 may therefore be configured to clamp the voltage V_{QR} to a predefined clamping voltage level in order to prevent an undefined increase of the voltage V_{QR} between the bias node Q and the further bias node R. According to one example, the clamping voltage level is relatively close to the voltage level of the bias voltage V_{DEP}. According to one example, the clamping voltage level is between 100% and 400% of the voltage level of the bias voltage V_{DEP}, such as between 100% and 120% of the voltage level of the bias voltage V_{DEP}, in particular between 100% and 110% of the voltage level of the bias voltage V_{DEP}.

According to one example, the clamping circuit 92 is integrated in the same semiconductor body as the superjunction transistor device TSJ. This may help to reduce the parasitic inductances, in particular, the parasitic inductance Lp22 between the clamping circuit 92 and the bias node Q and the bias region 4, respectively.

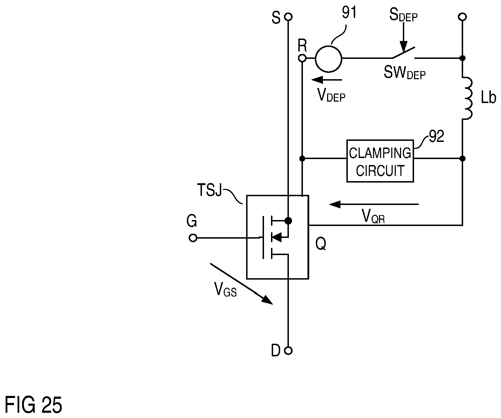

Figure 25 illustrates a modification of the transistor arrangement explained with reference to Figures 21 to 24. The transistor arrangement according to Figure 25 includes, in addition to parasitic line inductances (which are not illustrated in Figure 25) an inductor Lb connected between the bias voltage source 91 and the bias node Q. This inductor Lb has a defined inductance and may be implemented by suitably modifying the connection lines between the bias voltage source 91and the superjunction transistor device TSJ and/or by adding a discrete inductor. According to one example, an overall inductance, which is given by the parasitic inductance plus the inductance of the inductor Lb is between 10 nH and 20 nH, for example.

In the circuit arrangement according to Figure 25, the inductor Lb serves to increase the voltage V_{QR} between the bias node Q and the further bias node R to a voltage level that is higher than the voltage level of the bias voltage V_{DEP}. The function of this inductor LB is the same as the function of the parasitic inductances Lp1, Lp21, Lp22 explained with reference to Figure 24, wherein the inductance of the inductor Lb may be higher than the parasitic inductances Lp1, Lp21, Lp22. That is, energy is stored in the inductor Lb when the junction capacitance (see CC in Figure 24) is charged, wherein the energy stored in the inductor Lb is transferred to junction capacitance when the voltage V_{QR} between the bias nodes Q, R has reached the voltage level of the bias voltage V_{DEP} provided by the bias voltage source 91, so that the bias voltage V_{QR} between the bias nodes Q, R becomes higher than the bias voltage V_{DEP} provided by the bias voltage source 91.

The clamping circuit 92, which may be implemented in accordance with any of the examples explained herein before, clamps the voltage V_{QR} to a predefined clamping voltage level. According to one example, a clamping voltage level of the clamping circuit 92 is between 120% and 400% of the voltage level of the bias voltage V_{DEP}, in particular between 150% and 300% of the voltage level of the bias voltage V_{DEP}. According to one example, the bias voltage V_{DEP} provided by the bias voltage source 91 is selected from between 10V and 20V and the clamping voltage level is selected from between 20V and 50V.

## Claims

1. A transistor arrangement, comprising:
a superjunction transistor device (TSJ) comprising a source node (S), a gate node (G), a drain node (D) and a bias node (Q);
a bias voltage source (VS_{DEP}) configured to provide a bias voltage (V_{DEP});
an electronic switch (SW_{DEP}) configured to couple the bias voltage source (VS_{DEP}) between the bias node (Q) and a further bias node (R);
a drive circuit configured to drive the electronic switch (SW_{DEP}); and
a clamping circuit (92) coupled between the bias node (Q) and the further bias node (R) and configured to clamp a voltage between the bias node (Q) and the further bias node (R) to a clamping voltage level, and
wherein the drive circuit is further configured
to switch on the electronic switch (SW_{DEP}) during a transient phase in which the superjunction transistor device (TSJ) changes from a diode state to a blocking state, and
switch off the electronic switch (SW_{DEP}) when, during the transient phase, a drain-source voltage of the superjunction transistor device (TSJ) has reached a predefined threshold.

2. The transistor arrangement of claim 1, wherein the further bias node (R) is the source node (S).

3. The transistor arrangement of claim 1, wherein the further bias node (R) is different from the source node and coupled to a compensation region (21) of the superjunction transistor device (TSJ).

4. The transistor arrangement of any one of claims 1 to 3, wherein the clamping voltage level is between 100% and 400% of a bias voltage level of the bias voltage (VDEP).

5. The transistor arrangement of any one of the preceding claims, wherein an inductor (Lb) is connected between the bias voltage source (VS_{DEP}) and the bias node (Q).

6. The transistor arrangement of any one of the preceding claims, wherein the superjunction transistor device comprises:
at least one transistor cell (10) coupled to the source node (S), the drain node (D) and the gate node (G); and
a bias region (4) coupled to the bias node (Q).

7. The transistor arrangement of claim 6,
wherein the at least one transistor cell (10) comprises:
in a semiconductor body (100), a drift region (11) of a first doping type, a compensation region (21) of a second doping type complementary to the first doping type, a body region (22) of the second doping type, and a source region (12) of the first doping type; and
a gate electrode (31) dielectrically insulated from the body region (22) by a gate dielectric (32),
wherein the source region (12) and the body region (22) is coupled to the source node (S), and
wherein the gate electrode (31) is coupled to the gate node (G).

8. The transistor arrangement of claim 6 or 7,
wherein the bias region (4) is spaced apart from the body region (22) and the source region (12) and is coupled to the drift region (11).

9. The transistor arrangement of any one of claims 7 to 8,
wherein the compensation region (21) is spaced apart from the body region (22).

10. The transistor arrangement of claim 9,
wherein the gate electrode (31) is arranged in a gate trench (30), and
wherein the gate trench (30) is arranged between the compensation region (21) and the body region (22).

11. The transistor arrangement of any one of claims 7 to 8,
wherein the compensation region (21) adjoins the body region (22).

12. The transistor arrangement of any one of claims 6 to 11,
wherein the bias region (4) is of the first doping type.

13. The transistor arrangement of any one of claims 6 to 11,
wherein the bias region (4) is of the second doping type.

14. The transistor arrangement of any one of the preceding claims, further comprising:
a diode (6) connected between the bias region (4) and the bias voltage source.

15. The transistor arrangement of any one of the preceding claims, wherein the clamping circuit (92) and the superjunction transistor device (TSJ) are integrated in the same semiconductor body.

## Patentansprüche

1. Transistoranordnung, die aufweist:
ein Superjunction-Transistorbauelement (TSJ), das einen Sourceknoten (S), einen Gateknoten (G), einen Drainknoten (D) und einen Vorspannungsknoten (Q) aufweist;
eine Vorspannungsquelle (VS_{DEP}), die dazu ausgebildet ist, eine Vorspannung (V_{DEP}) bereitzustellen;
einen elektronischen Schalter (SW_{DEP}), der dazu ausgebildet ist, die Vorspannungsquelle (VS_{DEP}) zwischen den Vorspannungsknoten (Q) und einen weiteren Vorspannungsknoten (R) zu koppeln;
eine Ansteuerschaltung, die dazu ausgebildet ist, den elektronischen Schalter (SW_{DEP}) anzusteuern; und
eine Klemmschaltung (92), die zwischen den Vorspannungsknoten (Q) und den weiteren Vorspannungsknoten (R) gekoppelt ist und die dazu ausgebildet ist, eine Spannung zwischen dem Vorspannungsknoten (Q) und dem weiteren Vorspannungsknoten (R) auf einen Klemmspannungspegel zu klemmen, und
wobei die Ansteuerschaltung weiterhin dazu ausgebildet ist,
den elektronischen Schalter (SW_{DEP}) während einer Übergangsphase, in der das Superjunction-Transistorbauelement (TSJ) von einem Diodenzustand zu einem sperrenden Zustand wechselt, einzuschalten, und
den elektronischen Schalter (SW_{DEP}) auszuschalten, wenn während der Übergangsphase eine Drain-Source-Spannung des Superjunction-Transistorbauelements (TSJ) eine vorgegebene Schwelle erreicht hat.

2. Transistorbauelement nach Anspruch 1, wobei der weitere Vorspannungsknoten (R) der Sourceknoten (S) ist.

3. Transistoranordnung nach Anspruch 1, wobei sich der weitere Vorspannungsknoten (R) von dem Sourceknoten unterscheidet und an ein Kompensationsgebiet (21) des Superjunction-Transistorbauelements (TSJ) gekoppelt ist.

4. Transistoranordnung nach einem beliebigen der Ansprüche 1 bis 3, wobei der Klemmspannungspegel zwischen 100% und 400% eines Vorspannungspegels der Vorspannung (V_{DEP}) beträgt.

5. Transistoranordnung nach einem beliebigen der vorangehenden Ansprüche, wobei eine Induktivität (Lb) zwischen die Vorspannungsquelle (VS_{DEP}) und den Vorspannungsknoten (Q) gekoppelt ist.

6. Transistoranordnung nach einem beliebigen der vorangehenden Ansprüche, wobei das Superjunction-Transistorbauelement aufweist:
wenigstens eine Transistorzelle (10) die an den Sourceknoten (S), den Drainknoten (D) und den Gateknoten (G) gekoppelt ist; und
ein Vorspannungsgebiet (4), das an den Vorspannungsknoten (Q) gekoppelt ist.

7. Transistoranordnung nach Anspruch 6,
wobei die wenigstens eine Transistorzelle (10) aufweist:
in einem Halbleiterkörper (100), ein Driftgebiet (11) eines ersten Dotierungstyps, ein Kompensationsgebiet (21) eines zu dem ersten Dotierungstyp komplementären zweiten Dotierungstyps, ein Bodygebiet (22) des zweiten Dotierungstyps und ein Sourcegebiet (12) des ersten Dotierungstyps; und
eine Gateelektrode (31), die durch ein Gate-Dielektrikum (32) dielektrisch von dem Bodygebiet (22) isoliert ist,
wobei das Sourcegebiet (12) und das Bodygebiet (22) an den Sourceknoten (S) gekoppelt ist, und
wobei die Gateelektrode (31) an den Gateknoten (G) gekoppelt ist.

8. Transistoranordnung nach Anspruch 6 oder 7,
wobei das Vorspannungsgebiet (4) von dem Bodygebiet (22) beabstandet ist und das Sourcegebiet (12) an das Driftgebiet (11) gekoppelt ist.

9. Transistoranordnung noch einen beliebigen der Ansprüche 7 bis 8,
wobei das Kompensationsgebiet (21) zu dem Bodygebiet (22) beabstandet ist.

10. Transistoranordnung nach Anspruch 9,
wobei die Gateelektrode (31) in einem Gategraben (30) angeordnet ist, und
wobei der Gategraben (30) zwischen dem Kompensationsgebiet (21) und dem Bodygebiet (22) angeordnet ist.

11. Transistoranordnung nach einem beliebigen der Ansprüche 7 bis 8,
wobei das Kompensationsgebiet (21) an das Bodygebiet (22) angrenzt.

12. Transistoranordnung nach einem beliebigen der Ansprüche 6 bis 11,
wobei das Vorspannungsgebiet (4) vom ersten Dotierungstyps ist.

13. Transistoranordnung nach einem beliebigen der Ansprüche 6 bis 11,
wobei das Vorspannungsgebiet (4) vom zweiten Dotierungstyps ist.

14. Transistoranordnung nach einem beliebigen der vorangehenden Ansprüche, die weiterhin aufweist:
eine Diode (6), die zwischen das Vorspannungsgebiet (4) und die Vorspannungsquelle geschaltet ist.

15. Transistoranordnung nach einem beliebigen der vorangehenden Ansprüche, wobei die Klemmschaltung (92) und das Superjunction-Transistorbauelement (TSJ) im selben Halbleiterkörper integriert sind.

## Revendications

1. Montage de transistor comprenant :
un dispositif (TSJ) de transistor à superjonction comprenant un noeud (S) de source, un noeud (G) de grille, un noeud (D) de drain et un noeud (Q) de polarisation ;
une source (VS_{DEP}) de tension de polarisation configurée pour donner une tension (V_{DEP}) de polarisation ;
un interrupteur (SW_{DEP}) électronique configuré pour monter la source (VS_{DEP}) de tension de polarisation entre le noeud (Q) de polarisation et un autre noeud (R) de polarisation ;
un circuit de commande configuré pour commander l'interrupteur (SW_{DEP}) électronique ; et
un circuit (92) de fixation de niveau monté entre le noeud (Q) de polarisation et l'autre noeud (R) de polarisation et configuré pour fixer le niveau d'une tension entre le noeud (Q) de polarisation et l'autre noeud (R) de polarisation à un niveau de fixation de niveau de la tension et
dans lequel le circuit de commande est configuré en outre
pour fermer l'interrupteur (SW_{DEP}) électronique pendant une phase transitoire, dans laquelle le dispositif (TSJ) de transistor à superjonction passe d'un état de diode à un état de blocage, et
ouvrir l'interrupteur (SW_{DEP}) électronique lorsque, pendant la phase transitoire, une tension de drain-source du dispositif (TSJ) de transistor à superjonction a atteint un seuil défini à l'avance.

2. Montage de transistor suivant la revendication 1, dans lequel l'autre noeud (R) de polarisation est le noeud (S) de source.

3. Montage de transistor suivant la revendication 1, dans lequel l'autre noeud (R) de polarisation est différent du noeud de source et est relié à une région (21) de compensation du dispositif (TSJ) de transistor à superjonction.

4. Montage de transistor suivant l'une quelconque des revendications 1 à 3, dans lequel le niveau de fixation de niveau de la tension est compris entre 100% et 400% d'un niveau de la tension (V_{DEP}) de polarisation.

5. Montage de transistor suivant l'une quelconque des revendications précédentes, dans lequel une inductance (Lb) est montée entre la source (VS_{DEP}) de tension de polarisation et le noeud (Q) de polarisation.

6. Montage de transistor suivant l'une quelconque des revendications précédentes, dans lequel le dispositif de transistor à superjonction comprend :
au moins une cellule (10) de transistor reliée au noeud (S) de source, au noeud (D) de drain et au noeud (G) de grille et
une région (4) de polarisation reliée au noeud (Q) de polarisation.

7. Montage de transistor suivant la revendication 6,
dans lequel la au moins une cellule (10) de transistor comprend :
dans un corps (100) semi-conducteur, une région (11) de migration d'un premier type de dopage, une région (21) de compensation d'un second type de dopage complémentaire du premier type de dopage, une région (22) de corps du second type de dopage et une région (12) de source du premier type de dopage et
une électrode (31) de grille isolée diélectriquement de la région (22) de corps par un diélectrique (32) de grille,
dans lequel la région (12) de source et la région (22) de corps sont reliées au noeud (S) de source et
dans lequel l'électrode (31) de grille est reliée au noeud (G) de grille.

8. Montage de transistor suivant la revendication 6 ou 7,
dans lequel la région (4) de polarisation est à distance de la région (22) de corps et de la région (12) de source et est reliée à la région (11) de migration.

9. Montage de transistor suivant l'une quelconque des revendications 7 à 8,
dans lequel la région (21) de compensation est à distance de la région (22) de corps.

10. Montage de transistor suivant la revendication 9,
dans lequel l'électrode (31) de grille est disposée dans une tranchée (30) de grille et
dans lequel la tranchée (30) de grille est disposée entre la région (21) de compensation et la région (22) de corps.

11. Montage de transistor suivant l'une quelconque des revendications 7 à 8,
dans lequel la région (21) de compensation est contiguë de la région (22) de corps.

12. Montage de transistor suivant l'une quelconque des revendications 6 à 11,
dans lequel la région (4) de polarisation est du premier type de dopage.

13. Montage de transistor suivant l'une quelconque des revendications 6 à 11,
dans lequel la région (4) de polarisation est du second type de dopage.

14. Montage de transistor suivant l'une quelconque des revendications précédentes, comprenant en outre :
une diode (6) montée entre la région (4) de polarisation et la source de tension de polarisation.

15. Montage de transistor suivant l'une quelconque des revendications précédentes, dans lequel le circuit (92) de mise à niveau et le dispositif (TSJ) de transistor à superjonction sont intégrés dans le même corps semi-conducteur.
